# EUROPEAN PATENT APPLICATION

(11) **EP 4 117 016 A1**
(43) Date of publication of application: **11.01.2023**
(21) Application number: 21183804.0
(22) Date of filing: 05.07.2021
(51) Int. Cl.: H01J 37/244, H01J 37/317

(54) **CHARGED PARTICLE DETECTOR**

(71) Applicant: ASML Netherlands B.V., 5500 AH Veldhoven (NL)
(72) Inventor: MANGNUS, Albertus, Victor, Gerardus, 5500 AH Veldhoven (NL)
(74) Representative: ASML Netherlands B.V.

(57) **Abstract**

A detector for use in a charged particle device for an assessment apparatus to detect charged particles from a sample, wherein the detector comprises: a backscatter detector component set to a backscatter bias electric potential and configured to detect higher energy charged particles; and a secondary detector component set to a secondary bias electric potential and configured to detect lower energy charged particles; wherein there is a potential difference between the backscatter bias electric potential and the secondary bias electric potential.

## Description

### FIELD

The embodiments provided herein generally relate to charged-particle devices, detectors, and methods.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain data representing characteristics of the material structure of the surface of the sample. The data may be referred to as an image and may be rendered into an image.

Although the data obtained in this way can be useful, there are limitations in the information obtained about the sample from such known electron microscopy techniques. In general, there is a need to obtain additional or alternative information, for example, relating to structures below the surface of the sample and relating to overlay targets.

### SUMMARY

It is an object of the present disclosure to provide embodiments that support obtaining information from a sample using charged particles, for example, using backscattered and/or secondary signal particles.

According to an aspect of the invention there is provided a detector for use in a charged particle device for an assessment apparatus to detect charged particles from a sample, wherein the detector comprises: a backscatter detector component set to a backscatter bias electric potential and configured to detect higher energy charged particles; and a secondary detector component set to a secondary bias electric potential and configured to detect lower energy charged particles; wherein there is a potential difference between the backscatter bias electric potential and the secondary bias electric potential.

According to an aspect of the invention there is provided a detector for use in a charged particle device for an assessment apparatus to detect charged particles from a sample, the detector comprising a substrate comprising: at least two detector components each set to a respective bias electric potential and configured to detect a respective species of signal particle; wherein there is a potential difference between the respective bias electric potentials.

According to an aspect of the invention there is provided a detector for use in a charged particle device for an assessment apparatus to detect charged particles from a sample, wherein the detector comprises: a backscatter detector component configured to detect higher energy charged particles; and a secondary detector component configured to detect lower energy charged particles; wherein the backscatter detector component and the secondary detector component are of different types.

According to an aspect of the invention there is provided a detector for use in a charged particle device for an assessment apparatus to detect charged particles from a sample, the detector comprising a substrate comprising: at least two detector components of different types.

According to an aspect of the invention there is provided a method of projecting a beam of charged particles onto a sample so as to detect signal particles emitted from the sample, the method comprising: a) projecting the beam along a primary beam path onto a surface of the sample; and b) detecting the signal particles emitted from the sample simultaneously at a backscatter detector component set to a backscatter bias electric potential and at a secondary detector component set to a secondary bias electric potential, wherein there is a potential difference between the backscatter bias electric potential and the secondary bias electric potential.

According to an aspect of the invention there is provided a method of projecting a beam of charged particles onto a sample so as to detect signal particles emitted from the sample, the method comprising: a) projecting the beam along a primary beam path onto a surface of the sample; and b) detecting the signal particles emitted from the sample simultaneously at a backscatter detector component and at a secondary detector component, wherein the backscatter detector component and the secondary detector component are of different types.

According to an aspect of the invention there is provided a detector array for use in a charged particle device for an assessment apparatus to detect charged particles from a sample, the detector comprising a substrate comprising: at least two detector components of different types.

According to an aspect of the invention there is provided a detector array for use in a charged particle device for an assessment apparatus to detect charged particles from a sample, the detector array comprising a substrate in which is defined a plurality of apertures for the passage therethrough of a plurality of charged particle beams, the substrate comprising; at least two detector components associated with each aperture, each of the detector components set to a respective bias electric potential and configured to detect a respective species of signal particle; wherein there is a potential difference between the respective bias electric potentials.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary multi-beam apparatus according to an embodiment.
**FIG. 4** is a schematic cross-sectional view of an objective lens according to an embodiment.
**FIG. 5** is a schematic diagram of an exemplary charged particle optical device according to an embodiment.
**FIG. 6A** and **FIG. 6B** show a bottom view of variations of a detector.
**FIG. 7** is a schematic cross-sectional view of an objective lens comprising detectors located in various positions along a beam path.
**FIG. 8** is a schematic diagram of an exemplary charged particle-optical system comprising a macro collimator and macro scan deflector.
**FIG. 9** is a schematic diagram of an exemplary single beam apparatus according to an embodiment.
**FIGS. 10A, 10B and 10C** are schematic representations of a detector array and an associated cell array according an embodiment, a schematic representation of a cell of the cell array, and a cell of the cell array according to an embodiment.
**FIG. 11A** and **FIG. 11B** show a bottom view of variations of a detector.

The figures are schematic. The schematic diagrams and views show the components described below. However, the components depicted in the figures are not to scale. Relative dimensions of components in drawings are exaggerated for clarity. Within the following description of drawings the same or like reference numbers refer to the same or like components or entities, and only the differences with respect to the individual embodiments are described.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused primary beams, i.e. a multi-beam, of primary electrons. The component beams of the multi-beam may be referred to as sub-beams or beamlets or an array of primary beams. A multi-beam can scan different parts of a sample simultaneously. A multi-beam inspection apparatus can therefore inspect a sample at a much higher speed than a single-beam inspection apparatus. An implementation of a known multi-beam inspection apparatus is described below.

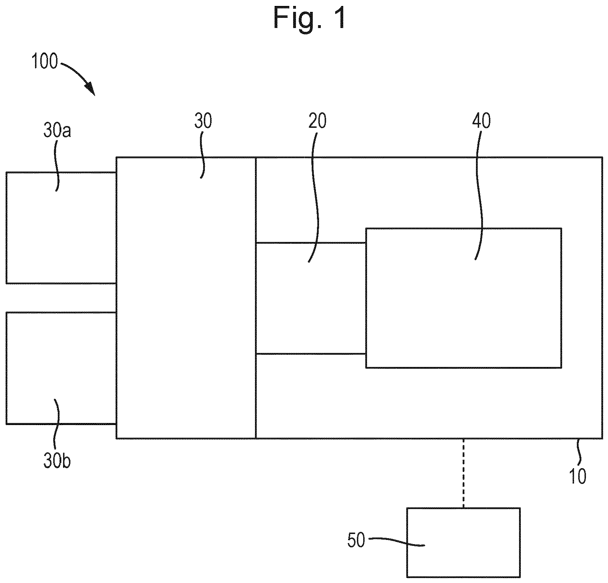

Reference is now made to **FIG. 1****,** which is a schematic diagram illustrating an exemplary charged particle beam inspection apparatus 100. The charged particle beam inspection apparatus 100 of **FIG. 1** includes a main chamber 10, a load lock chamber 20, an charged particle beam tool 40 (which may otherwise be referred to as an electron beam tool), an equipment front end module (EFEM) 30 and a controller 50. The charged particle beam tool 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle beam tool 40 by which it may be inspected. An charged particle beam tool 40 may comprise a multi-beam charged particle -optical apparatus.

The controller 50 is electronically connected to the charged particle beam tool 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing a charged particle beam inspection tool, it should be noted that aspects of the disclosure in their broadest sense are not limited to a chamber housing an charged particle beam inspection tool. Rather, it is appreciated that the foregoing principles may also be applied to other tools and other arrangements of apparatus, that operate under the second pressure.

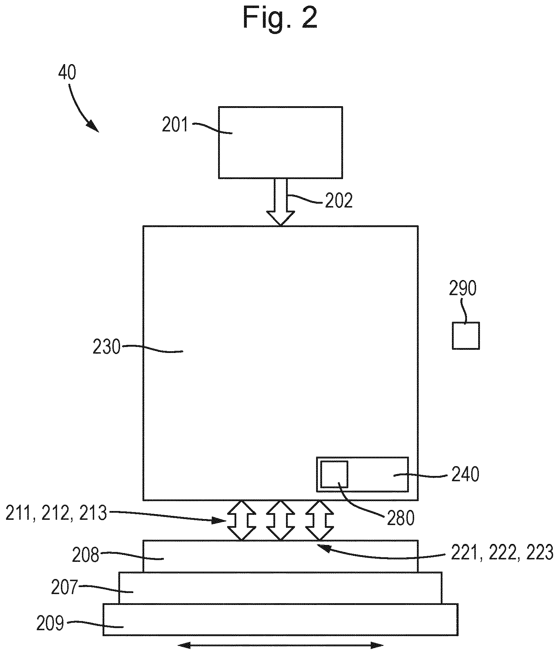

Reference is now made to **FIG. 2****,** which is a schematic diagram illustrating an exemplary charged particle beam tool 40 including a multi-beam inspection tool that is part of the exemplary charged particle beam inspection apparatus 100 of **FIG. 1****.** The multi-beam charged particle beam tool 40 (also referred to herein as apparatus 40) comprises an charged particle source 201, a projection apparatus 230, a motorized stage 209, and a sample holder 207. The charged particle source 201 and projection apparatus 230 may together be referred to as an illumination apparatus. The sample holder 207 is supported by motorized stage 209 so as to hold a sample 208 (e.g., a substrate or a mask) for inspection. The multi-beam charged particle beam tool 40 further comprises a detector array 240 (e.g. an electron detection device).

The controller 50 may be connected to various parts of the charged particle beam inspection apparatus 100 of **FIG. 1****.** The controller 50 may be connected to various parts of the charged particle beam tool 40 of **FIG. 2****,** such as the charged particle source 201, the detector array 240, the projection apparatus 230, and the motorized stage 209. The controller 50 may perform various data, image and/or signal processing functions. The controller 50 may also generate various control signals to govern operations of the charged particle beam inspection apparatus 100, including the charged particle multi-beam apparatus. The controller 50 may control the motorized stage 209 to move sample 208 during inspection of the sample 208. The controller 50 may enable the motorized stage 209 to move the sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particle (e.g. electrons) as primary charged particles from the cathode. The primary charged particles are extracted or accelerated by the extractor and/or the anode to form a primary charged particle beam 202. The charged particle source 201 may comprise multiple sources, such as described in EP20184161.6, which is hereby incorporated by reference at least with respect to the multiple sources and how they relate to multiple columns and their associated charged particle-optics.

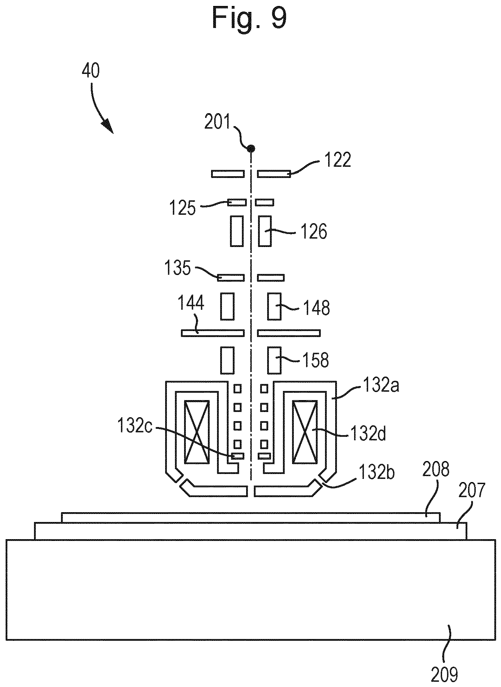

The projection apparatus 230 is configured to convert the primary charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets. Furthermore, although the present description and figures relate to a multi-beam system, a single beam system may be used instead in which the primary charged particle beam 202 is not converted into multiple sub-beams. This is described further below in relation to **FIG. 9** , but it will be noted that the sub-beams may be interchangeable with a single primary charged particle beam 202.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The secondary signal particles typically have charged particle energy ≤ 50 eV. Actual secondary signal particles can have an energy of less than 5 eV, but anything beneath 50 eV is generally treated as a secondary signal particle. Backscatter signal particles typically have energy between 0 eV and the landing energy of the primary sub-beams 211, 212, and 213. As signal particles detected with an energy of less than 50 eV are generally treated as a secondary signal particles, a proportion of the actual backscatter signal particles will be counted as secondary signal particles. The secondary signal particles may more specifically be referred to, and are interchangeable with, secondary electrons. The backscatter signal particles may more specifically be referred to, and are interchangeable with, backscatter electrons. The skilled person would understand that the backscatter signal particles may more generally be described as secondary signal particles. However, for the purposes of the present disclosure, the backscatter signal particles are considered to be different from the secondary signal particles, e.g. having higher energies. In other words, the secondary signal particles will be understood to be particles having kinetic energy ≤ 50 eV when emitted from the sampled and the backscatter signal particles will be understood to be particles having kinetic energy higher than 50 eV when emitted from the sample. In practice, the signal particles may be accelerated before being detected and thus, the energy range associated with the signal particles may be slightly higher. For example, the secondary signal particles will be understood to be particles having kinetic energy ≤ 200 eV when detected at a detector and the backscatter signal particles will be understood to be particles having kinetic energy higher than 200 eV when detected at a detector. It is noted that the 200 eV value may vary depending on the extent of acceleration of the particles, and may for example be approximately 100 eV or 300 eV. Secondary signal particles having such values are still considered to have sufficient energy different with respect to the backscatter signal particles.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 so as to form an image. The signal processing system 280 could otherwise be referred to as an image processing system or a data processing system. The signal processing system may be incorporated into a component of the multi-beam charged particle beam tool 40 such as the detector array 240 (as shown in **FIG. 2****).** However, the signal processing system 280 may be incorporated into any components of the inspection apparatus 100 or multi-beam charged particle beam tool 40, such as, as part of the projection apparatus 230 or the controller 50. The signal processing system 280 could be located outside of the structure that includes the main chamber which is shown in **FIG. 1****.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam tool 40 and charged particle beam inspection apparatus 100 described above, are disclosed in US2020118784, US20200203116, US 2019/0259570 and US2019/0259564 which are hereby incorporated by reference.

In known single-beam systems, different signals (e.g. from secondary signal particles and/or backscatter signal particles) might theoretically be detected. Multi-beam systems are known and are beneficial as the throughput can be much higher than when using single-beam systems, e.g. the throughput of a multi-beam inspection system may be 100 times higher than the throughput in a single-beam inspection system.

In known multi-beam systems, an array of primary sub-beams of charged particles at a relatively high energy are targeted with a final deceleration step in order to land on a sample at a relatively low landing energy for detection of secondary signal particles as mentioned above. However, in practice, it has not generally been possible to use multi beam inspection in combination with backscatter detection, or at least by direct backscatter detection, i.e. presently known multi-beam systems rely primarily on detection of secondary signal particles. However, there are limitations in the information which can be obtained solely from secondary signal particles. Backscatter signal particles provide information about structures below the surface, such as buried defects. Additionally, backscatter signals can be used to measure overlay targets.

As described above, backscatter signal particles have a large range of energies, typically between 0 eV and the landing energy. The backscatter signal particles have a large range in energy (for example up to the landing energy of the primary beam) and wide angle of emitted backscatter signal particles. Secondary signal particles typically have a more restricted energy range and tend to be distributed around an energy value. The large energy range and wide angle of emitted backscatter signal particles results in cross-talk in a multi-beam system. Cross-talk occurs when backscatter signal particles resulting from one primary sub-beam are detected at a detector assigned to a different sub-beam. Cross-talk generally occurs very close to the sample 208, i.e. proximate the sample onto which the primary beam is projected. Due to the cross-talk, previously known multi-beam assessment tools have not been able to effectively image backscatter signals. As a consequence, it has not been possible to increase the throughput for backscattered detection by using multi-beam systems.

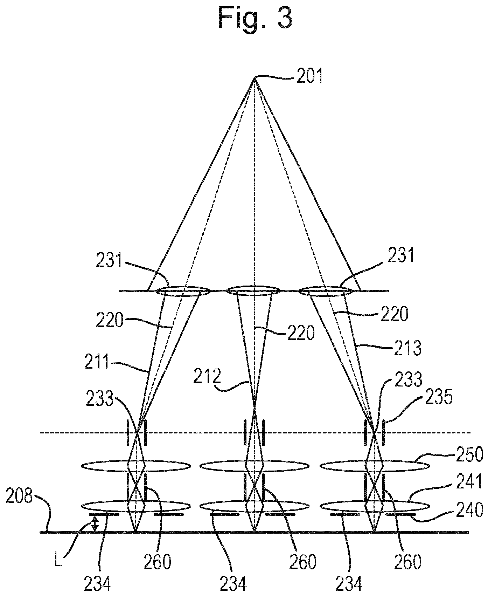

Components of an assessment tool 40 which may be used in the present invention are described below in relation to **FIG. 3** which is a schematic diagram of an assessment tool 40. The charged particle assessment tool 40 of **FIG. 3** may correspond to the multi-beam charged particle beam tool (also referred to herein as apparatus 40).

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect. More generally, the condenser lens array 231 may have two or more plate electrodes each with an array of apertures that are aligned. Each plate electrode array is mechanically connected to, and electrically isolated from, an adjacent plate electrode array by an isolating element, such as a spacer which may comprise ceramic or glass. The condenser lens array may be connected and/or spaced apart from an adjacent charged particle-optical element, preferably an electrostatic charged particle-optical element, by an isolating element such as a spacer as described elsewhere herein.

The condenser lenses may be separated from a module containing the objective lenses (such as an objective lens array assembly as discussed elsewhere herein). In a case where the potential applied on a bottom surface of the condenser lenses is different than the potential applied on the top surface of the module containing the objective lenses an isolating element (e.g. a spacer) is used to space apart the condenser lenses and the module containing the objective lenses. In a case where the potential is equal then a conductive element can be used to space apart the condenser lenses and the module containing the objective lenses.

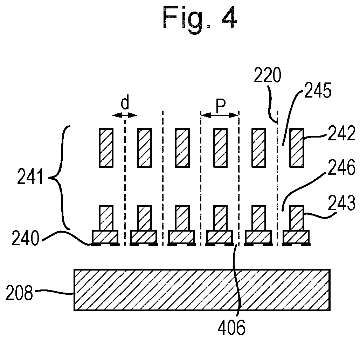

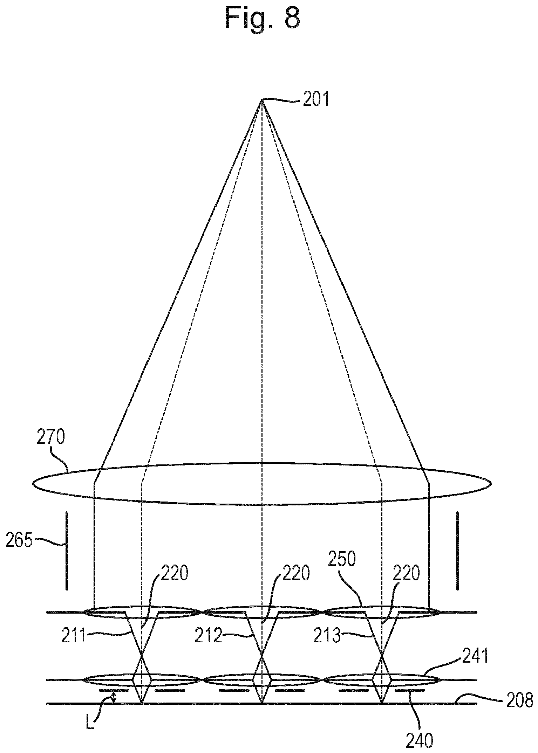

Each condenser lens 231 in the array directs a primary beam of charged particles into a respective sub-beam 211, 212, 213 which is focused at a respective intermediate focus down beam of the condenser lens array. The respective sub-beams are projected along respective sub-beam paths 220. The sub-beams diverge with respect to each other. The sub-beam paths 220 diverge down beam of the condenser lenses 231. In an embodiment, deflectors 235 are provided at the intermediate focuses. The deflectors 235 are positioned in the sub-beam paths at, or at least around, the position of the corresponding intermediate focusses 233 or focus points (i.e. points of focus). The deflectors are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Down beam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. The collimator may comprise a macro collimator 270, instead of, or in addition to the deflectors 235. Thus, the macro-collimator 270 described below in relation to **FIG. 8** may be provided with the features of **FIG. 3** or **FIG. 4****.** This is generally less preferred than providing the collimator array as deflectors 235.

Below (i.e. down beam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations.

In further detail, it is desirable to use the control lens array 250 to determine the landing energy. However, it is possible to use in addition the objective lens array 240 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location, for example in, on or otherwise associated with the objective lens. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array electrodes may be spaced a few millimeters (e.g. 3mm) apart. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned up-beam of the objective lens array 241. Up-beam may be defined as being closer to the source 201. Up-beam may otherwise be defined as further from the sample 208. The control lens array 250 may be in the same module as an objective lens array 241, i.e. forming an objective lens array assembly or objective lens arrangement, or it may be in a separate module. In this case, the arrangement may be described as four or more lens electrodes that are plates. In the plates are defined apertures, for example as aperture arrays, that are aligned with a number of sub-beams in a corresponding beam array. The electrodes may be grouped into two or more electrodes, for example to provide a control electrode group, and an objective electrode group. In an arrangement the objective electrode group has at least three electrodes and the control electrode group has at least two electrodes. Alternatively, if the control lens array 250 and the objective lens array 240 are separate, the spacing between the control lens array 241 and the objective lens array 250 (i.e. the gap between lower electrode of the control lens array 250 and the upper electrode of the objective lens 241) can be selected from a wide range, e.g. from 2 mm to 200 mm or more. A small separation makes alignment easier whereas a larger separation allows a weaker lens to be used, reducing aberrations.

Each plate electrode of the control lens array 250 is preferably mechanically connected to, and electrically separated from, an adjacent plate electrode array by an isolating element, such as a spacer which may comprise ceramic or glass. Each plate electrode of the objective lens array is preferably mechanically connected to, and electrically separated from, an adjacent plate electrode array by an isolating element, such as a spacer which may comprise ceramic or glass. The isolating element may otherwise be referred to as an insulating structure, and may be provided to separate any adjacent electrodes provided, such as in the objective lens array 240, the condenser lens array (as depicted in **FIG. 3****)** and/or the control lens array 250. If more than two electrodes are provided, multiple isolating elements (i.e. insulating structures) may be provided. For example, there may be a sequence of insulating structures.

The control lens array 250 comprises a control lens for each sub-beam 211, 212, 213. A control lens adds optical degrees of freedom to the function of the associated objective lens. A control lens may comprise of one or more electrode or plates. The addition of each electrode may provide a further degree of freedom of the control of the charged particle-optical function of the associated objective lens. In an arrangement the function of the control lens array 250 is to optimize the beam opening angle with respect to the demagnification of the beam and/or to control the beam energy delivered to the objective lenses 234, each of which directs a respective sub-beam 211, 212, 213 onto the sample 208. The objective lenses may be positioned at or near the base of the charged particle-optical system. More specifically, the objective lens array may be positioned at or near the base of the projection system 230. The control lens array 250 is optional, but is preferred for optimizing a sub-beam upbeam of the objective lens array.

For ease of illustration, lens arrays are depicted schematically herein by arrays of oval shapes (as shown in **FIG. 3****).** Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The objective lens array 241 may comprise at least two electrodes in which are defined aperture arrays. In other words, the objective lens array comprises at least two electrodes with a plurality of holes or apertures. Adjacent electrodes of the objective lens array 241 are spaced apart from each other along the sub-beam paths. The distance between adjacent electrodes along the beam path, in which an insulating structure might be positioned as described below, is smaller than the size of an objective lens (along the beam path, i.e. between the most upbeam and most down beam electrode of the objective lens array). **FIG. 4** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of sub-beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The aperture arrays 245, 246 of the objective lens array 241 may consist of a plurality of apertures, preferably with substantially uniform diameters, d. However there may be some variation for optimizing aberration correction as described in EP Application 20207178.3 filed on 12 November 2020 which is herein incorporated by reference at least with respect to corrections achieved by varying aperture diameter. The diameter, d, of the apertures in at least one electrode may be less than approximately 400 µm. Preferably, the diameter, d, of the apertures in at least one electrode is between approximately 30 to 300 µm. Smaller aperture diameters may provide larger detectors of the detector array 240 for a given aperture pitch, improving the chance of capturing backscatter signal particles. Thus the signal for the backscatter signal particles may improve. However, having apertures that are too small risk inducing aberrations in the primary sub-beams. The plurality of apertures in an electrode may be spaced apart from each other by a pitch, P. The pitch, P, is defined as the distance from the middle of one aperture to the middle of an adjacent aperture. The pitch between adjacent apertures in at least one electrode may be less than approximately 600 µm. Preferably, the pitch between adjacent apertures in at least one electrode is between approximately 50 µm and 500 µm. Preferably, the pitch between adjacent apertures on each electrode is substantially uniform. The values for the diameter and/or pitch described above can be provided in at least one electrode, multiple electrodes, or all electrodes in an objective lens array. Preferably, the dimensions referred to and described apply to all electrodes provided in an array of objective lenses.

The objective lens array 241 may comprise two or three electrodes or may have more electrodes (not shown). An objective lens array 241 having only two electrodes can have fewer aberrations, e.g. a lower aberration risk and/or impact, than an objective lens array 241 having more electrodes. A three-electrode objective lens can have greater potential differences between the electrodes and so enable a stronger lens. Additional electrodes (i.e. more than two electrodes) provide additional degrees of freedom for controlling the charged particle trajectories, e.g. to focus secondary signal particles as well as the incident beam. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array. The objective lens array 241 can be configured to demagnify the charged particle beam by a factor greater than 10, desirably in the range of 50 to 100 or more. Each element in the objective lens array 240 may be a micro-lens operating a different sub-beam or group of sub-beams in the multi-beam.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

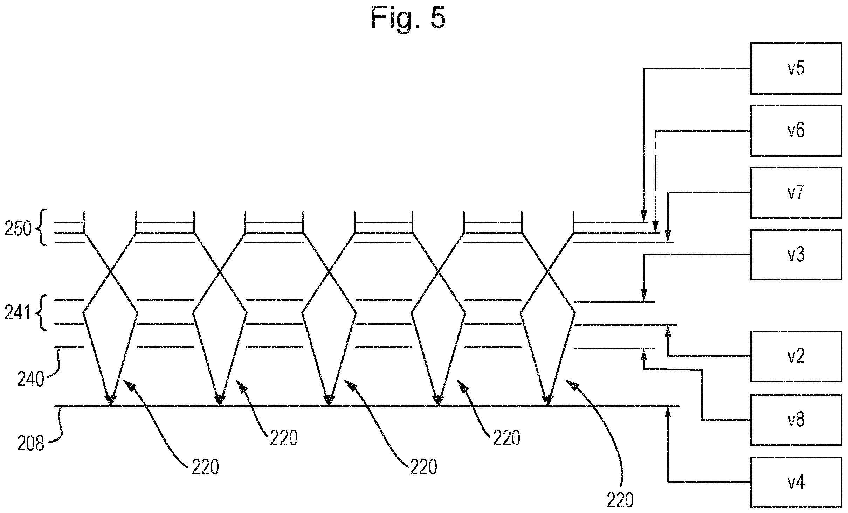

**FIG. 5** is an enlarged schematic view of multiple objective lenses of the objective lens array 241 and multiple control lenses of the control lens array 250. As described in further detail below, the lens arrays can be provided by electrodes with a selected potential applied to the electrode by a voltage source, i.e. electrodes of the arrays are connected to respective potential sources. In **FIG. 5****,** multiple lenses of each of the control lens array 250, the objective lens array 241 and the detector array 240 are depicted, for example, with any of sub-beams 211, 212, 213 passing through the lenses as shown. Although **FIG. 5** depicts five lenses, any appropriate number may be provided; for example, in the plane of the lenses, there may be 100, 1000 or of the order of 10,000 lenses. Features that are the same as those described above are given the same reference numerals. For conciseness, the description of these features provided above applies to the features shown in **FIG. 5****.** The charged particle optical device may comprise one, some or all of the components shown in **FIG. 5****.** Note that this figure is schematic and may not be to scale. For example, in a non-limited list: the sub-beams may be narrower at the controller array 250 than at the objective lens array 241; the detector array 240 may be closer to the electrodes of the objective lens array 241 than the electrodes of the objective lens array 241 are to each other; and a focus point of each sub-beam between the controller lens array 250 may be closer to the objective lens array 241 than depicted. Spacing between electrodes of the control lens array 250 may be larger than spacing between electrodes of the objective lens array 241 as shown in **FIG. 5****,** but this is not a necessity.

As shown in **FIG. 5****,** the sub-beams may be parallel on entry into the control lens array 250, as shown in **FIG. 3****.** However, the same components of **FIG. 5** may be used in a configuration as shown in **FIG. 8****,** in which case, the sub-beams may be separated (or generated) from a beam from a source further down beam. For example, the sub-beams may be defined by a beam limiting aperture array which may be part of a lens arrangement such as an objective lens array, a control lens array, or any other lens element that may be associated with an objective lens array for example that is part of an objective lens array assembly. As depicted in **FIG. 8****,** the sub-beams may be separated from the beam from the source by a beam limiting aperture array that may be part of the control lens array 250 as a most up beam electrode of the control lens array 250.

Voltage sources V3 and V2 (which may be provided by individual electric power sources, or may all be supplied by electric power source 290) are configured to apply potentials to the upper and lower electrodes of the objective lens array 241 respectively. The upper and lower electrodes may be referred to as an up-beam electrode 242 and a down-beam electrode 243 respectively. Voltage sources V5, V6, V7 (which may be provided by individual electric power sources, or may all be supplied by electric power source 290) are configured to apply potentials to the first, second and third electrodes of the control lens array 250 respectively. A further voltage source V4 is connected to the sample to apply a sample potential. A further voltage source V8 is connected to the detector array to apply a detector array potential. Although the control lens array 250 is shown with three electrodes, the control lens array 250 may be provided with two electrodes (or more than three electrodes). Although the objective lens array 240 is shown with two electrodes, the objective lens array 240 may be provided with three electrodes (or more than three electrodes). For example, a middle electrode may be provided in the objective lens array 241 between the electrodes shown in **FIG. 5** with a corresponding voltage source, V1 (not shown). Desirably, the potential V5 of the uppermost electrode of the control lens array 250 is maintained the same as the potential of the next charged particle-optic element up-beam of the control lens (e.g. deflectors 235). The potential V7 applied to the lower electrode of the control lens array 250 can be varied to determine the beam energy. The potential V6 applied to the middle electrode of the control lens array 250 can be varied to determine the lens strength of the control lens and hence control the opening angle and demagnification of the beam. It should be noted that even if the landing energy does not need to be changed, or is changed by other means, the control lens can be used to control the beam opening angle. The position of the focus of a sub-beam is determined by the combination of the actions of the respective control lens array 250 and the respective objective lens 240.

The detector array 240 (which may otherwise be referred to as an array of detectors) comprises a plurality of detectors. Each detector is associated with a corresponding sub-beam (which may otherwise be referred to as a beam or primary beam). In other words, the arrays of detectors (i.e. the detector array 240) and sub-beams correspond. Each detector may be assigned to a sub-beam. The array of detectors may correspond with the array of objective lenses. In other words, the array of detectors may be associated with the corresponding array of objective lenses. A detector array 240 is described below. However, any reference to detector array 240 could be replaced with a single detector (i.e. at least one detector) or multiple detectors as appropriate. The detectors may otherwise be referred to as of detector elements 405 (e.g. sensor elements such as capture electrodes). The detectors may be any appropriate type of detector.

The detector array 240 may be positioned at a position along the primary beam path at any location between an upper beam position and a lower beam position along the beam path. The upper beam position is above the objective lens array and optionally any associated lens arrays such as a control lens array (i.e. up beam of an objective lens array assembly). The lower beam position is down beam of the objective lens array. In an arrangement the detector array may be an array that is up beam of the objective lens array assembly. The detector array may be associated with any electrode of the objective lens array assembly. Reference hereafter of a detector in association with an electrode of the objective lens array may correspond to an electrode of the objective lens array assembly, except for the most down beam surface of the most down beam electrode of the objective lens array, unless stated explicitly otherwise.

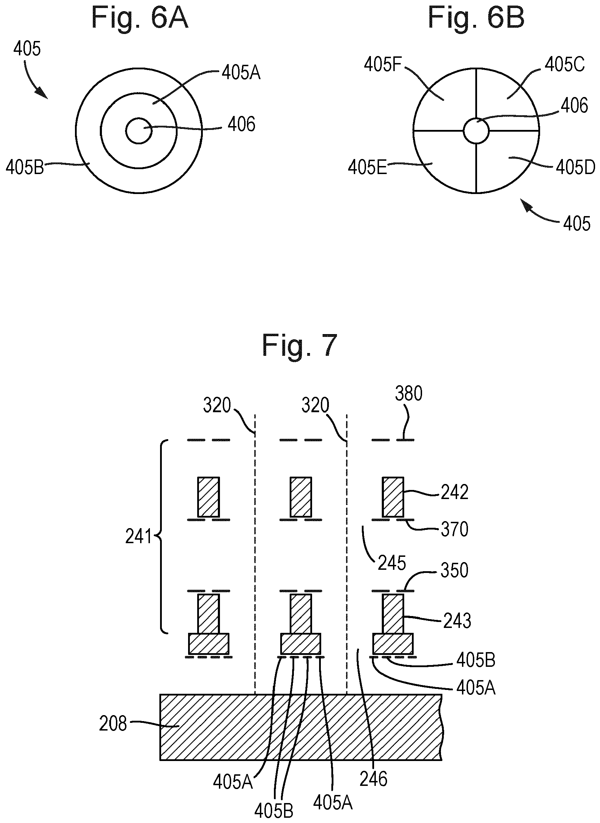

In an arrangement the detector array 240 may be positioned between the control lens array 250 and the sample 208. The detector array 240 may be positioned between the objective lenses 234 and the sample 208, as shown in **FIG. 4** and **FIG. 5****.** Although this may be preferable, the detector array 240 could be provided in additional or alternative locations, such as those depicted in **FIG. 7****.** Multiple detector arrays may be provided in a variety of locations, e.g. as in **FIG. 7****.** The signal particles, including backscatter signal particles may be detected directly from the surface of the sample 208. Thus, the backscatter signal particles may be detected without having to be converted, for example, into another type of signal particle such a secondary signal particle which may be easier to detect. Thus, the backscatter signal particles may be detected by the detector array 240 without encountering, e.g. hitting, any other components or surfaces between the sample 208 and the detector array 241.

The detector array is positioned between the objective lens array 241 and the sample 208. The detector array 240 is configured to be proximate the sample. The detector array 240 may be proximate the sample so as to detect backscatter signal particles from the sample 208. The detector being proximate the sample enables the risk of cross-talk in detection of backscatter signal particles generated by sub-beams which correspond to another detector in the detector array to be reduced if not avoided. In other words, the detector array 240 is very close to the sample 208. The detector array 240 may be within a certain distance of the sample 208, as described below. The detector array 240 may be adjacent to the sample 208. The at least one detector may be positioned in the device so as to face the sample. That is the detector may provide a base to the device. The detector as part of the base may face a surface of the sample. This may be beneficial in positioning the at least one detector in a location in which the at least one detector is more likely to detect backscatter particles than secondary particles. For example, the at least one detector array may be provided on an output side of the objective lens array 241. The output side of the objective lens array 241 is the side on which the sub-beams are output from the objective lens array 241, i.e. the bottom or downbeam side of the objective lens array in the configuration shown in **FIG. 3****,** **FIG. 4** and **FIG. 5****.** In other words, the detector array 240 may be provided downbeam of the objective lens array 241. The detector array may be positioned on, or adjacent to, the objective lens array. The detector array 241 may be an integral component of the objective lens array 241. The detector and objective lens may be part of the same structure. The detector may be connected to the lens by an isolating element or directly to an electrode of the objective lens. Thus, the at least one detector may be part of an objective lens assembly comprising at least the objective lens array and the detector array. If the detector array is an integral component of the objective lens array 241, the detector array 240 may be provided at the base of the objective lens array 241. In an arrangement the detector array 240 may be integral to the most-down-beam positioned electrode of the objective lens array 241.

Ideally, the detector array is as close as possible to the sample. The detector array 240 is preferably very close to the sample 208 such that there is a proximity focus of backscatter signal particles at the detector array. As previously described, the energy and angular spread of the backscatter signal particles is generally so large that it is difficult (or impossible in known prior art systems) to keep the signals from neighboring sub-beams separated. However, the proximity focus means that backscatter signal particles can be detected at a relevant one of the detectors without cross-talk (i.e. interference from neighboring sub-beams) in the first aspect. Of course, there is a minimum distance between the sample 208 and the detector array 240. However, it is preferable to reduce this distance as much as possible. Certain configurations may benefit from reducing the distance even more than others.

Preferably, a distance 'L' as shown in **FIG. 3****,** between the detector array 240 and the sample 208 is less than or equal to approximately 50 µm, i.e. the detector array 240 is positioned within approximately 50 µm from the sample 208. Although is generally preferably that the distance L is small (e.g. between around 10 to 65 microns), as this can improve detector efficiency and/or reduce cross-talk, the distance may be greater. For example, the distance L may be approximately 100 microns or less, or approximately 200 microns or less. The distance L is determined as the distance from a surface of the sample 208 facing the detector array 240 and a surface of the detector array 241 facing the sample 208. Providing a distance of approximately 50 µm or less is beneficial in that cross-talk between backscatter signal particles can be avoided or minimized. Theoretically, there may be a lower limit of how close the sample 208 and the detector array 240 can be whilst allowing these components to move relative to each other and this may mean that the distance L might be more than approximately 5 µm or 10 µm. For example, a distance L of approximately 50 µm or less may be used whilst still allowing relatively reliable control of the device as shown as part of the tool in **FIG. 3****.** A distance L of approximately 30 µm or less may be preferable for other configurations, such as those shown and described in relation to **FIG. 8** below. A preferred range of the distance L between the detector array 240 and the sample 208 may be between approximately 5 µm to 200 µm, or preferably between approximately 5 µm to 100 µm, or preferably between approximately 5 µm to 50 µm, or preferably between approximately 10 µm to 50 µm, or preferably between approximately 30 µm to 50 µm. In an arrangement the detector array 240 may be actuatable relative to the objective lens array 241, i.e. to vary the distance L, for example to substantially maintain a distance between the sample and the detector array L. It is noted that the distance L described here is for a multi-beam system as shown in **FIG. 3** (or **FIG. 8****).** The same distance may be used in a single beam device, e.g. as shown in **FIG. 9****,** although the distance L may be larger for the single beam device.

The backscatter signal particles are emitted from the sample 208 with a very large energy spread, and typically with an angular spread following a cosine distribution which may take the appearance in three dimensions of a cone. The further the distance from sample 208 to the detector array 240, the larger the cone of the emitted beam becomes. It will be understood that the backscatter signal particles can have all angles. The cone of the emitted beam is the solid angle assignable to the detector associated with a respective beam, so that this solid angle is larger with greater proximity of the sample and the detector. Because of the very large energy spread it may not be possible to image the backscatter signal particles coming from the different sub-beams onto a detector without introducing significant cross talk. The solution is to place the detector in close proximity to the substrate, and choose the pitch of the sub-beams such that the backscatter signal particle signals of the neighbouring sub-beams to not overlay.

Thus, the pitch size, P, as discussed above may be selected depending on the distance between the detector array 240 and the sample 208 (or vice versa). For example only, for a distance L between the sample 208 and the detector array 240 of approximately 50 micron, the sub-beam pitch p may be equal to or larger than approximately 300 micron. Such a combination may be particularly useful for detecting high energy signal particles, e.g. backscatter signal particles, with an accelerating lens. For example only, for a distance L between the sample 208 and the detector array 240 of approximately 10 micron, the sub-beam pitch p may be equal to or larger than approximately 60 micron. Providing a closer detector array allows use of a smaller sub-beam pitch p. This may be beneficial in using certain configurations in which the sub-beam pitch is beneficially smaller, such as the configuration described in relation to, and shown in, **FIG. 8** below. In a different example arrangement the distance between the sample 208 an the detector array 240 is approximately 50 micron and the sub-beam pitch p is approximately 60 micron. Such a different set up is intended for different operational settings and to detect a different type of signal particle. For example, such a combination may be particularly useful for detecting low energy signal particles, e.g. secondary signal particles, with a decelerating lens. For simultaneous detection of high energy particles (e.g. backscatter signal particles) and low energy particles (e.g. secondary signal particles), the pitch p and distance L may be selected between the values described above so that the high energy particle and low energy particle signals are sufficiently large. It will be noted that there is no relation or limitation for the distance L and the pitch p for the functioning of the detector. However, due to a risk of crosstalk in neighboring detectors it might be preferable to use a larger pitch p for a larger distance L. Although, there may also be other ways to reduce the risk of crosstalk and any appropriate combination of pitch p and distance L may be used.

The detector array 240 (and optionally the objective lens array 241) may be configured to repel secondary signal particles emitted from the sample 208. This is beneficial as it reduces the number of secondary signal particles emitted from the sample 208 which travel back towards the detector array 240. The difference in potential between the detector array 240 and the sample 208 can be selected to repel signal particles emitted from the sample 208 away from the detector array 240. Preferably, the detector array potential may be the same as the potential of the downbeam electrode of the objective lens array. The potential difference between the sample potential and the detector array potential is preferably relatively small so that primary sub-beams are projected through or past the detector array 240 to the sample 208 without being significantly affected. Additionally, a small potential difference will have a negligible effect on the path of a backscatter signal particle (which generally has a greater energy up to the landing energy), meaning that the backscatter signal particles can still be detected whilst reducing or avoiding detection of secondary signal particles. The potential difference between the sample potential and the detector array potential is preferably greater than a secondary signal particle threshold. The secondary signal particle threshold may determine the minimum initial energy of secondary signal particles that can still reach the detector. Preferably, the secondary signal particle threshold is the potential difference equivalent to the likely energy of a secondary signal particle emanating from the sample 208. That is the relatively small potential difference between the sample and detector array potentials is sufficient to repel the secondary signal particles from the detector array. For example, the potential difference between the sample potential and the detector array potential may be approximately 20 V, 50 V, 100 V, 150 V, 200 V, 250 V, or 300V.

The objective lens array 241 may be configured to accelerate the primary charged particles (i.e. the sub-beams) towards the sample 208 along the sub-beam paths 220. Accelerating the sub-beams 211, 212, 213 projected onto the sample 208 is beneficial in that it can be used to generate an array of sub-beams with high landing energy. The potentials of the electrodes of the objective lens array can be selected to provide acceleration through the objective lens array 241. It is noted that an accelerating lens in the arrangement may be particularly useful for detecting ranges (e.g. different energy ranges) of backscatter signal particles. Alternatively, the objective lens array may be configured to decelerate the primary charged particles towards the sample 208 along the sub-beam paths 220. It is noted that a decelerating lens in the arrangement may be particularly useful for detecting both secondary and backscatter signal particles. The figures described below, and particularly **FIG. 3****,** **FIG. 5** and **FIG. 8****,** show the objective lens in the accelerating mode. However, as will be understood from the description above, the objective lens may be used in the decelerating mode instead for any of the embodiments and variations described below. In other words, **FIG. 3****,** **FIG. 5** and **FIG. 8** could be adapted to decelerate the sub-beams through the objective lenses.

In an arrangement of accelerating objective lens array 241, the low energy particles (e.g. secondary signal particles) generally cannot pass up-beam of the lower part of the accelerating objective lens. It is also increasing difficult for high energy particles (e.g. backscatter signal particles) to pass the accelerating objective lens. This is a key point for both accelerating and decelerating objective lenses. The energy difference between the low energy signal particles (e.g. secondary signal particles) and high energy signal particles (e.g. backscatter signal particles) is proportionately larger down-beam of the objective lens (in both accelerating and decelerating mode) than at any point up-beam of the objective lens. This is beneficial for detection using the detectors described below to distinguish between the different types of signal particles.

The potentials and the values of the potentials defined herein are defined with respect to the source; hence the potential of a charged particle at the surface of the sample may be referred to as a landing energy because the energy of a charged particle correlates to the potential of the charged particle and the potential of the charged particle at the sample is defined with respect to the source. However, as the potentials are relative values, the potentials could be defined relative to other components, such as the sample. In this instance, the difference in potential applied to different components would preferably be as discussed below with respect to the source. The potentials are applied to the relevant components, such as the electrodes and the samples during use, i.e. when the device is being operated.

For example, the device being configured to accelerate the charged particle sub-beams and repel the secondary signal particles as described above may have potentials as shown in the context of **FIG. 5** with the values in Table 1 below. As mentioned above, the objective lens array as shown in **FIG. 5** may comprise an additional electrode, e.g. a middle electrode. Such a middle electrode is optional and need not be included with the electrodes having the other potentials listed in Table 1. The middle electrode of the objective lens array may have the same potential (e.g. VI) as the upper electrode of the objective lens array (i.e. V3).

Exemplary ranges are shown in the left hand column of Table 1 as described above. The middle and right hand columns show more specific example values for each of V1 to V8 within the example ranges. The middle column may be provided for a smaller resolution than the right hand column. If the resolution is larger (as in the right hand column), the current per sub-beam is larger and therefore, the number of sub-beams may be lower. The advantage of using a larger resolution is that the time needed to scan a "continuous area" is shorter (which can be a practical constraint). So the overall throughput may be lower, but the time needed to scan the beam area is shorter (because the beam area is smaller).

**Table 1**

| | | | |
|---|---|---|---|
| Landing Energy | > 10-100 keV | 30 keV | 30 keV |
| V1 (or omitted) | 1-10 keV | 5 keV | 5 keV |
| V2 | > 10-100 keV | 29.95 keV | 29.95 keV |
| V3 | 1-10 keV | 5 keV | 5 keV |
| V4 | > 10-100 keV | 30 keV | 30 keV |
| V5 | > 10-100 keV | 30 keV | 30 keV |
| V6 | 1-30 keV | 4.4 keV | 10 keV |
| V7 | 1-10 keV | 5 keV | 5 keV |
| V8 | > 10-100 keV | 29.95 keV | 29.95 keV |

For example, the device being configured to decelerate the charged particle sub-beams and repel the secondary signal particles as described above may have potentials as shown in the context of **FIG. 5** with the values in Table 2 below. The values of the potentials provided for the accelerating lens might be swapped and adjusted to provide a deceleration. For example only, the charged particles may be decelerated from 30kV to 2.5kV in the objective lens. In an example, to obtain landing energies in the range of 1.5 kV to 5 kV, potentials shown in **FIG. 5****,** such as V2, V3, V4, V5, V6 and V7, can be set as indicated in Table 2 below. V1 is optionally included if a middle objective lens electrode is included. The potentials and landing energies shown in Table 2 are examples only and other landing energies could be obtained, for example, the landing energy could be lower than 1.5 kV (e.g. approximately 0.3 kV or 0.5 kV) or higher than 5 kV. It will be seen that the beam energy at V1, V3 and V7 is the same. In embodiments the beam energy at these points may be between 10 keV and 50 keV. If a lower potential is selected, the electrode spacings may be reduced, especially in the objective lens, to limit reduction of the electric fields. The potentials in this table are given as values of beam energy in keV, which is equivalent to the electrode potential relative to the cathode of the beam source 201. It will be understood that in designing an charged particle-optical system there is considerable design freedom as to which point in the system is set to a ground potential and the operation of the system is determined by potential differences rather than absolute potentials.

**Table 2**

| | | | | |
|---|---|---|---|---|
| Landing Energy | 1.5 keV | 2.5 keV | 3.5 keV | 5 keV |
| V1 (or omitted) | 29 keV | 30 keV | 31 keV | 30 keV |
| V2 | 1.55 keV | 2.55 keV | 3.55 keV | 5.05 keV |
| V3 | 29 keV | 30 keV | 31 keV | 30 keV |
| V4 | 1.5 keV | 2.5 keV | 3.5 keV | 5 keV |
| V5 | 30 keV | 30 keV | 30 keV | 30 keV |
| V6 | 19.3 keV | 20.1 keV | 20.9 keV | 30 keV |
| V7 | 29 keV | 30 keV | 31 keV | 30 keV |
| V8 | 1.55 keV | 2.55 keV | 3.55 keV | 5.05 keV |

In order to maximize the detection efficiency it is desirable to make the surface of the detector elements 405 as large as possible, so that substantially all the area of the objective lens array 240 (excepting the apertures) is occupied by detector elements 405. Additionally or alternatively, each detector element 405 has a diameter substantially equal to the array pitch (i.e. the aperture array pitch described above in relation to the electrodes of the objective lens assembly 241). In an embodiment the outer shape of the detector element 405 is a circle, but this can be made a square or a hexagon to maximize the detection area.

However a larger surface for the detector elements 405 leads to a larger parasitic capacitance, so a lower bandwidth. For this reason it may be desirable to limit the outer diameter of the detector elements 405. Especially in case a larger detector element 405 gives only a slightly larger detection efficiency, but a significantly larger capacitance. A circular (annular) detector element 405 may provide a good compromise between collection efficiency and parasitic capacitance. A larger outer diameter of the detector element 405 may also lead to a larger crosstalk (sensitivity to the signal of a neighboring hole). This can also be a reason to make the outer diameter of the detector element 405 smaller. Especially in case a larger detector element 405 gives only a slightly larger detection efficiency, but a significantly larger crosstalk.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In some embodiments, one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment tool. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different sub-beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream (or down-beam). The condenser lenses and correctors may be part of the same structure. For example they may be connected to each other, for example with an electrically isolating element. The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. The objective lenses and/or control lenses and correctors may be part of the same structure. For example they may be connected to each other, for example with an electrically isolating element. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

In an embodiment, a single detector element 405 surrounds each beam aperture 406. In another embodiment, a plurality of detector elements 405 are provided around each beam aperture 406. Thus, the detector comprises multiple portions, and more specifically, multiple detecting portions. The different portions may be referred to as different zones. Thus the detector may be described to have multiple zones or detection zones. Such a detector may be referred to as a zoned detector. The signal particles captured by the detector elements 405 surrounding one beam aperture 406 may be combined into a single signal or used to generate independent signals. The detector comprising multiple portions may be provided in any of the detector arrays described herein.

The zoned detector may be associated with one of the sub-beams 211, 212, 213. Thus, the multiple portions of one detector may be configured to detect signal particles emitted from the sample 208 in relation to one of the sub-beams 211, 212, 213. The detector comprising multiple portions may be associated with one of the apertures in at least one of the electrodes of the objective lens assembly. More specifically, the detector 405 comprising multiple portions may be arranged around a single aperture 406 as shown in **FIG. 6A** and **FIG. 6B****,** which provide examples of such a detector.

The portions of the zoned detector may be separated in a variety of different ways, e.g. radially, annular, or any other appropriate way. Preferably the portions are of similar angular size and/or similar area and/or similar shape, for example as shown in **FIG. 6B****.** The separated portions may be provided as a plurality of segments, a plurality of annular portions (e.g. a plurality of concentric annuli or rings), and/or a plurality of sector portions (i.e. radial portions or sectors). The detector elements 405 may be divided radially. For example, the at least one detector 405 may be provided as annular portions comprising 2, 3, 4, or more portions. More specifically, as shown in **FIG. 6A****,** the detector 405 may comprise an inner annular portion 405A surrounding aperture 406 and an outer annular portion 405B, radially outwards of the inner annular portion 405A. Alternatively, the detector elements 405 may be divided angularly. For example, the detector may be provided as sector portions comprising 2, 3, 4, or more portions, for example 8, 12 etc.. If the detector is provided as two sectors, each sector portion may be a semi-circle. If the detector is provided as four sectors, each sector portion may be a quadrant. This is shown in **FIG. 6B** in which the 405 is divided into quadrants, i.e. four sector portions is shown in **FIG. 6B****,** as described below. Alternatively, the detector may be provided with at least one segment portion. The electrode elements may be separated both radially and angularly or in any other convenient manner.

Each portion may have a separate signal read-out. The detector being separated into portions, e.g. annular portions or sector portions, is beneficial in that it allows more information to be obtained in relation to the signal particles detected. Thus, providing the detector 405 with multiple portions may be beneficial in obtaining additional information relating to the detected signal particles. This can be used to improve the signal to noise ratio of the detected signal particles. However, there is an additional cost in terms of the complexity of the detector.

As shown in **FIG. 6A****,** the detector, in which an aperture 406 is defined and configured for the through passage of a charged particle beam, comprises inner detecting portion 405A and outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. In an example, the detector may be divided into two (or more) concentric rings, for example, as depicted in **FIG. 6A****.**

Providing multiple portions concentrically or otherwise may be beneficial because different portions of the detector may be used to detect different signal particles, which may be smaller angle signal particles and/or larger angle signal particles, or secondary signal particles and/or backscatter signal particles. Such a configuration of different signal particles may suit a concentrically zoned detector. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features.

**FIG. 8** is a schematic diagram of an exemplary charged particle-optical system having the charged particle device as in any of the above described options or aspects. The charged particle optical device having at least the objective lens array 241 as described in any of the aspects or embodiments above may be used in the charged particle-optical system as shown in **FIG. 8****.** For conciseness, features of the objective lens array 241 that have already been described above may not be repeated here.

There are some considerations specific to the set up of **FIG. 8****.** In the present embodiment, it is preferable to keep the pitch small so as to avoid negatively impacting throughput. However, when the pitch is too small, this can lead to cross-talk. Therefore, the pitch size is a balance of effective detection of a selected signal particle such as a backscatter signal particle and throughput. Thus, the pitch is preferably approximately 300 µm in such an arrangement for detection of backscatter signal particles , which is 4-5 times larger than it might otherwise be for the embodiment of **FIG. 8** when detecting secondary signal particles. When the distance between the detector and the sample 208 is reduced, the pitch size can also be reduced without negatively affecting the cross-talk. Therefore, providing the detector as close as possible to the sample (i.e. with distance L as small as possible, and preferably less than or equal to approximately 50 µm, or less than or equal to approximately 40 µm, or less than or equal to approximately 30 µm, or less than or equal to approximately 20 µm, or equal to approximately 10 µm), is beneficial in allowing the pitch to be as large as possible which improves throughput.

As shown in **FIG. 8****,** the charged particle-optical system comprises a source 201. The source 201 provides a beam of charged particles (e.g. electrons). The multi-beam focused on the sample 208 is derived from the beam provided by the source 201. Sub-beams 211, 212, 213 may be derived from the beam, for example, using a beam limiter (which may otherwise be referred to as a beam limiting aperture array) defining an array of beam-limiting apertures. The beam may separate into the sub-beams 211, 212, 213 on meeting the control lens array 250. The sub-beams 211, 212, 213 are substantially parallel on entry to the control lens array 250. (In an arrangement, the control lens array 250 comprises the beam limiter.) The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 collimates the beam from the source such that beam cross-section is substantially consistent on incidence with the beam limiter. The macro collimator 270 bends respective portions of the beam from which the sub-beams are derived by an amount effective to ensure that a beam axis of each of the sub-beams is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses.

In another arrangement (not shown), the macro-collimator may be partially or wholly replaced by a collimator element array provided down-beam of the upper beam limiter. Each collimator element collimates a respective sub-beam. The collimator element array may be formed using MEMS manufacturing techniques so as to be spatially compact. The collimator element array may be the first deflecting or focusing charged particle-optical array element in the beam path down-beam of the source 201. The collimator element array may be up beam of the control lens array 250. The collimator element array may be in the same module as the control lens array 250.

In the embodiment of **FIG. 8** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

In another arrangement (not shown), the macro scan deflector 265 may be partially or wholly replaced by a scan deflector array. The scan-deflector array 260 comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). The scan deflector array may be up beam of an objective lens array 241. The scan deflector array may be down beam of a control lens array 250. Although reference is made to a single sub-beam associated with a scan deflector, groups of sub-beams may be associated with a scan deflector. In an embodiment, the scanning deflectors described in EP2425444, which document is hereby incorporated by reference in its entirety specifically in relation to scan deflectors, may be used to implement the scan-deflector array. A scan-deflector array (e.g. formed using MEMS manufacturing techniques as mentioned above) may be more spatially compact than a macro scan deflector. The scan deflector array may be in the same module as the objective lens array 241.

In other embodiments both a macro scan deflector 265 and the scan-deflector array are provided. In such an arrangement, the scanning of the sub-beams over the sample surface may be achieved by controlling the macro scan deflector and the scan-deflector array 260 together, preferably in synchronization.

The invention can be applied to various different tool architectures. For example, the charged particle beam tool 40 may be a single beam tool, or may comprise a plurality of single beam columns or may comprise a plurality of columns of multi-beams (i.e. sub-beams). The columns may comprise the charged particle optical device described in any of the above embodiments or aspects. As a plurality of columns (or a multi-column tool), the devices may be arranged in an array which may number two to one hundred columns or more. The charged particle device may take the form of an embodiment as described with respect to and depicted in **FIG. 3** or as described with respect to and depicted in **FIG. 8****,** although preferably having an electrostatic scan deflector array and/or an electrostatic collimator array for example in the objective lens array assembly. The charged particle optical device may be a charged particle optical column. A charged particle column may optionally comprise a source.

As described above, the array of detectors 240 may be provided between the objective lens array 241 and the sample 208, as shown in **FIG. 4** and **FIG. 5****.** The array of detectors 240 may be associated with at least one electrode of the objective lens array, preferably, the lower electrode 243. Preferably, the down-beam array of detectors 240 faces the sample 208 in use, i.e. when the sample is present.

Additional or alternative detector arrays may be provided which may be positioned in other places. This is depicted in **FIG.7****.** One, some or all of the detector arrays as shown in **FIG. 7** might be provided. If multiple detector arrays are provided, they may be configured to detect signal particles simultaneously. The detector array 240 positioned between the objective lens array 241 and the sample 208 is shown as a zoned detector as described in relation to **FIG. 6A** and **FIG. 6B****.** However, any appropriate type of detector may be used for this array.

The charged particle-optical device may comprise an array of detectors, referred to herein as an array of mirror detectors 350. The array of mirror detectors 350 is arranged along the primary beam paths 320 (e.g. at a common position along the primary beam path). The array of mirror detectors 350 is configured to face up-beam of the primary beam paths 320. In other words, the array of mirror detectors 350 is configured to face along the primary beam path 320 towards a source of the primary beam (described above as source 201). The array of mirror detectors 350 is configured to face away from the sample 208. The array of mirror detectors 350 may otherwise be referred to as an upwards array of detectors. Preferably, the array of mirror detectors 350 is associated with the lower electrode 243, and preferably an up-beam surface of the electrode. This may be beneficial as the signal particles may be more likely to be detected if the array of mirror detectors 350 are provided relatively close to the sample 208, e.g. just above or on the lower electrode 343. When the array of mirror detectors 350 is positioned within the objective lens array 241 (i.e. between electrodes of the objective lens array 241) it may be referred to as an in-lens detector. In an arrangement of an objective lens array assembly with multiple lensing electrodes, other electrodes may feature a mirror electrode, so long as another electrode is located up beam of the mirror electrode to mirror the signal particles towards the mirror electrode.

The charged particle-optical device may comprise at least one up-beam array of detectors facing towards the sample, i.e. in the direction of the sample 208. In other words, the up-beam array of detectors may be facing in a direction along the primary beam path 320 towards the sample 208. The charged particle-optical device may comprise upper array of detectors 370. The upper array of detectors 370 may be associated with the down-beam surface of the upper electrode 242 of the objective lens array 241. More generally, the upper array of detectors 370 could be associated with a down-beam surface of any appropriate electrode if more electrodes are provided in the objective lens array. The upper array of detectors 370 may be positioned between the upper electrode 342 and the lower electrode 343, or between any other electrodes above the lowest electrode of the objective lens array. As described above, the upper array of detectors 370 is provided up-beam (in relation to the primary sub-beams 211 and 212) of at least one electrode, which is the lower electrode 243 in relation to **FIG. 7****.** Additionally or alternatively, the charged particle-optical device may comprise an above-lens array of detectors 380. In other words, the up-beam array of detectors may be above the objective lens array 241. The above-lens array of detectors 380 may be up-beam of all the electrodes forming the objective lens array 241. The above-lens array of detectors 380 may be spaced apart from the electrode 242 so that the above-lens detector array 380 is a plate or substrate with its own mechanical support separate from the objective lens array.

Any of the detector arrays may be associated with (e.g. in, on, positioned adjacent to, connected to, or integrated with) at least one electrode of the objective lens array 241 (e.g. either the upper electrode 242 or the lower electrode 243). For example, the array of detectors may be in or on at least one electrode of the objective lens array 241. For example, the array of detectors may be positioned adjacent to one of the electrodes. In other words, the array of detectors may be positioned in close proximity and next to one of the electrodes. For example, the array of detectors may be connected (e.g. mechanically connected) to one of the electrodes. In other words, the array of detectors may be attached to one of the electrodes, e.g. by adhesive or welding or some other attachment method. For example, the array of detectors may be integrated with the one of the electrodes. In other words, the array of mirror detectors may be formed as part of one of the electrodes.

Combinations of the detector arrays may be provided. For example, the down-beam array of detectors 240 and/or the array of mirror detectors 350 and/or the upper array of detectors 370 and/or the above-lens array of detectors 380 may be provided. The device may comprise an additional array of detectors which may be provided with any combination of the down-beam array of detectors 240 and/or the array of mirror detectors 350 and/or the upper array of detectors 370 and/or the above-lens array of detectors 380. As will be clear from the above described combinations of arrays, there could be any appropriate number of detector arrays. For example, there could be two, or three, or four, or five, or more arrays of detectors which are positioned at any appropriate place, for example, as described above in relation to the up-beam array of detectors and/or the down-beam array of detectors. Whichever detector arrays are provided may be used simultaneously. A potential of any of the detector arrays (e.g. the array of mirror detectors 350 and/or the upper array of detectors 370 and/or the above-lens array of detectors 380 and/or the down-beam array of detectors 360 and/or any additional array of detectors) relative to a potential of the sample 208 may be selected to control detection of the signal particles at least that detector array. The array of sub-beams (otherwise referred to as an array of primary beams) may correspond with any/all detector arrays provided. Thus, the array of sub-beams may correspond with the array of mirror detectors 240, and/or the down-beam array of detectors 360, and/or the upper array of detectors 370 and/or above-lens array of detectors 380. Thus, any/all of the detector arrays may be aligned with the sub-beams.

**FIG. 9** is a schematic diagram of an exemplary single beam charged particle beam tool 40 according to an embodiment. As shown in **FIG. 9****,** in an embodiment the charged particle beam tool 40 comprises a sample holder 207 supported by a motorized stage 209 to hold a sample 208 to be inspected. The charged particle beam tool 40comprises an charged particle source 201. The charged particle beam tool 40 further comprises a gun aperture 122, a beam limit aperture 125 (or beam limiter), a condenser lens 126, a column aperture 135, an objective lens assembly 132, and an charged particle detector 144 (which may otherwise be referred to as an electron detector). The objective lens assembly 132, in some embodiments, may be a modified swing objective retarding immersion lens (SORIL), which includes a pole piece 132a, a control electrode 132b, a deflector 132c, and an exciting coil 132d. The control electrode 132b has an aperture formed in it for the passage of the charged particle beam. The control electrode 132b forms the surface facing the sample 208. Although the charged particle beam tool 40 shown in **FIG. 9** is a single beam system, in an embodiment a multi-beam system is provided. Such a multi-beam system may have the same features as shown in **FIG. 9****,** such as the objective lens assembly 132. Such a multi-beam system may have in addition beam limiter array, for example down-beam of the condenser lens, for generating the sub-beams. Associated with the beam limiter array, such as down beam of the beam limiter array, may be a number of charged particle array elements such a deflector array and a lens array for optimizing and adjusting the sub-beams and reducing aberrations of the sub-beams. Such a multi-beam system may have a secondary column for detecting signal charged particles. A Wien filter may be up-beam of the objective lens assembly to direct the signal particles towards a detector in the secondary column.

In an imaging process, a charged particle beam emanating from the source 201 may pass through the gun aperture 122, the beam limit aperture 125, the condenser lens 126, and be focused into a probe spot by the modified SORIL lens and then impinge onto the surface of sample 208. The probe spot may be scanned across the surface of the sample 208 by the deflector 132c or other deflectors in the SORIL lens. Signal particles emanated from the sample surface may be collected by the charged particle detector 144 to form an image of an area of interest on the sample 208.

The condenser and illumination optics of the charged particle beam tool 40may comprise or be supplemented by electromagnetic quadrupole charged particle lenses. For example, as shown in **FIG. 9** the charged particle beam tool 40 may comprise a first quadrupole lens 148 and a second quadrupole lens 158. In an embodiment, the quadrupole lenses are used for controlling the charged particle beam. For example, first quadrupole lens 148 can be controlled to adjust the beam current and second quadrupole lens 158 can be controlled to adjust the beam spot size and beam shape.

As described above, a zoned detector may have a plurality of detector portions (e.g. sensor elements) as part of a detector element 405 as described above in relation to **FIG. 6A** and **FIG. 6B****.** The plurality of detector portions for each detector element (or sensor unit) is provided around an aperture. The plurality of detector portions may, together, have a circular perimeter and/or a diameter. The plurality of detector portions may, together, have an area extending between the aperture and the perimeter of the plurality of detector portions. The pluralities of detector elements may be arranged in rectangular array or a hexagonal array. The signal generated from signal particles captured by detector portions surrounding one aperture may be combined into a single signal or used to generate independent signals. The surfaces of the detector elements, optionally their detector portions, may substantially fill the surface of the substrate supporting the detector elements.

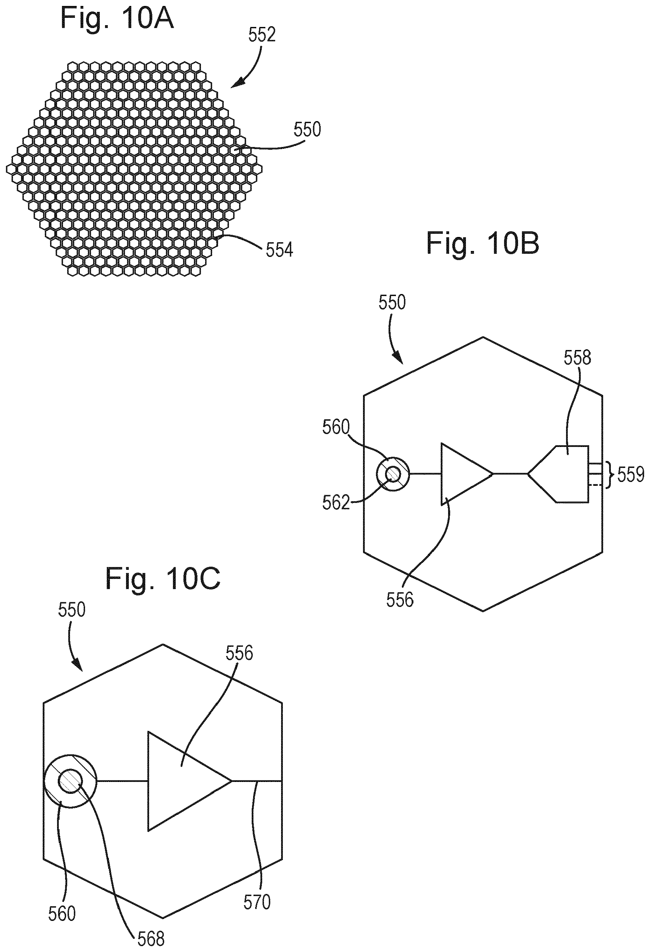

As shown in **FIG. 10A** a surface of a detector array or detector module facing, even proximate in use to, a sample features an array of detector elements (or an array of detectors). Each detector element is associated with an aperture. Each detector element is associated with an assigned surface area of the substrate of the detector module . As the substrate is layered, for example in having a CMOS structure, each layer within the substrate is positioned with respect to the respective detector elements, preferably proximately. Commercially available CMOS structures have a usual range of layers, for example three to ten, usually about five. (For example, two functional layers may be provided for ease of description. These two layers of wiring layer and logic layer may represent as many layers as required and each layer is not restricted to wiring or logic, respectively.) The number of layers is limited by commercial availability and any number of layers is feasible. However, in view of practicality, the substrate has a limited number of layers, in order for an efficient design the available space is limited.

Ideally a circuit layer of the substrate, which can be the wiring layer and/or logic layer, has a portion assigned for each detector element (or detector). The assigned portions of the different layers may be referred to as a cell 550. The arrangement of portions in the substrate for the full multi-beam arrangement may be referred to as a cell array 552. The cells 550 may be same shape as the surface area assigned for each detector element, such as hexagonal, or any reasonable shape that may tesselate and may all be similar in shape and/or area, such as a rectangular shape. Having a rectangular or rectilinear shape can more readily be used by placing and routing design. Such design is commonly implemented by software that is suited to define chips with an rectangular type architecture with orthogonal directions, than architecture requiring acute or obtuse angles such as in a hexagonal architecture. In **FIG 10A** the cells 550 are depicted as being hexagonal and the cell array 552 is depicted as a hexagon comprising individual cells. However, ideally each similarly located with respect to detector elements. Wiring routes 554 may connect to each cell 550. The wiring routes 554 may be routed between other cells of the cell array 552. Note: reference to wiring routes to be between cells of the array, it is intended that at least the wiring routes avoid the beam apertures of the array of apertures, e.g. defined through the cell array. In an arrangement circuit architecture, the cell size in at least the circuit layer may be reduced to accommodate the wiring routes, so that the wiring routes are routed between cells. Additionally or alternatively the wiring routes pass through the cells of the cell array, preferably towards the perimeter of the cells for example to reduce the interference of the wiring routes with other circuitry in the cells. Therefore reference to a wiring route between the cells encompasses: a wiring route between the circuitry of cells, a wiring route within cells, preferably towards the periphery of the cells and at least around the beam apertures through the cells and any intermediate variation. In all these arrangements, for example in a CMOS architecture, the wiring routes may be in the same die as the other circuitry which may define circuitry in the same cell as a portion of the wiring route, or circuitry in a cell around which the wiring route is routed. Thus, the cells and wiring routes may parts of a monolithic structure. The wiring routes 554 may signally connect the cells. Thus the wiring routes signally connect the cells 550 to a controller or data processor external to the cell array or even the substrate or detector module. The circuit layer may comprise a datapath layer for the transmission of sensor signals from a cell outward of the cell array.

The controller or data processor may before circuitry within the substrate or detector module, preferably external to the cell array for example as control and I/O circuitry (not shown). The control and I/O circuitry may be in the same die as the cell array; the control and I/O circuitry may be monolithically integrated with the cell array, for example in the same CMOS chip. The control and to I/O circuitry enables an efficient connection between the data from all the cells of the cell array 552. Consider for example an arrangement of 2791 cells each having an 8 bit digital output. Such an arrangement would have 22328 signals (i.e. 8 bit output *2791 cells) to the electronics located outside the CMOS chip. The standard way of doing this is to use a SERDES circuitry (serializer / de-serializer). Such circuitry would transform a large number of low data rate signals into a few number of high data rate signals by means of time division multiplexing. It is therefore beneficial to have control and I/O circuitry monolithically with the cell array, or at least in the detector module, than external to the detector module.

In embodiments the control and I/O circuitry may feature general supporting functions, such as circuitry to communicate with the electronics outside the CMOS chip to enable loading certain settings, for example for control of amplification and offset such as subtraction as described herein.

The circuit layer of a cell 550 is connected to a detector element of the respective cell. The circuit layer comprises circuitry having amplification and/ digitation functions, e.g. it may comprise a amplification circuit. A cell 550 may comprise a trans impedance amplifier (TIA) 556 and an analogue to digital converter (ADC) 558 as depicted in **FIG. 10B****.** This figure schematically depicts a cell 550 with an associated detector element such as capture electrode and a feedback resistor 562 connected to the transimpedance amplifier 556 and the analogue to digital converter 558. The digital signal lines 559 from the analogue to digital converter 558 leave the cell 550. Note that the detector element is represented as a detector element 560 and feedback resistor is shown associated with the detector area as a disc 562 rather than associated with the transimpedance amplifier 556. This schematic representation is to represent each of the detector element and the feedback resistor as an area to indicate their relative size, the reason for which will become apparent when referring to **FIG. 10C****.**

The transimpedance amplifier may comprise a feedback resistor Rf 562. The magnitude of the feedback resistor Rf should be optimized. The larger the value of this feedback resistor, the lower the input referred current noise. Thus the better signal-to noise ratio at the output of the transimpedance amplifier. However, the larger the resistance, Rf, the lower the bandwidth. A finite bandwidth results in a finite rise and fall time of the signal, resulting in additional image blur. An optimized Rf results in a good balance between noise level and additional image blur.

To implement the design the circuitry i.e. the amplification circuitry associated with each detector element should be within the layers of the associated cell 550 and fit in the limited area available of the portions of each associated layer. In the case of a sub-beam pitch of 70 micron, the available area per layer in the cell is typically only 4000 square micron. Depending on the sensed secondary and/or backscatter signal particles, for example as current to be measured by the detector element, the optimum value for the feedback resistor Rf can be as high as 30 to 300 MOhm. If such a resistor would be implemented as a poly resistor in a standard CMOS process the size of such resistor would be much larger than the area that is available in the CMOS layers of the cell 550. For example, a resistor of 300 MOhm would consume around 500000 micron^2. This is about 130 times larger than the entire available area.

Typically, for example in CMOS architecture, such a large resistor would be made in a single layer for example of polysilicon. Usually there is a single layer of polysilicon. In some circumstances a layer could be provided having material capable of providing high resistor values, although with such a high aspect ratio (e.g. extreme length relative to width of the resistive structure in the layer) the reliability of the resistor remains. Even if the cell were to have multiple layers used for such a resistor, many more layers would have to be present that is readily available for example using CMOS technology. Additionally or alternatively, the meandering path through different layers would not mitigate the high aspect ratio and risk of variation in the resistance value would only be contributed by the interconnections between different layers. Such interconnects influence the variability of the resistance value of a resistor as a corner, as later described herein.

Note that such dimensions are calculated assuming a 180 nm node architecture and processing. If alternatively a smaller processing node is used, it is unlikely that a factor of thousand in reducing the dimensions of the resistor structure could be gained. Further, using 180 nm node architecture is preferred to a smaller node for processing reasons. For instance interconnects in a 180 nm node are simpler to process. Post processing of a detector chip for example in etching the beam apertures 504 uses aluminum interconnects. Such post processing at a sub-180nm node typically uses a process with Copper interconnects. Processing at 180 nm is therefore simpler than at sub-180 nm.

Further if such a resistor were made, in whichever node, the reliability of the resistor specifications as well as the space available for the resistor may be challenging.

In a layered structure for chip architecture, such as CMOS, the components and features are defined as structures in a layer. The specification of a component is dependent on the material of the layer and the physical properties of the layer, the dimensions of the layer, specifically its thickness and the dimensions of the structure formed in the layer. A resistor may take the form of a long narrow path, route or wire. In view of space constraints, the path may be non-linear, having corners along its path. For such a long component, the width of the path in the layer may vary such as through manufacturing tolerances. A corner may provide greater variance than a linear section of the path, limiting the accuracy with which the resistor can be made in order to have a specified resistance. With many corners and a long length, a resistor having such topology may made with poor reliability so that the resistances for equivalent resistors in different cells of the cell array may have a large range.

Such a resistive structure has a large surface area. Additionally or alternatively, a resistor with such a large surface area would additionally have a capacitance which is undesirable; such a capacitance is referred to as a parasitic capacitance. Parasitic capacitances may undesirably contribute to noise and blur, influencing the balance between noise, blur and bandwidth optimization which is elsewhere herein described

The material properties of the layer can be modified chemically; however such modifications are unlikely to achieve the improvement of several orders of magnitude in size to fit into available space in the cell. Such modifications are unlikely to change the topography of the feedback resistor sufficiently so that has the required specification and can be made with the desired reliable accuracy.

Such requirements in reliability and size would enable the resistor to achieve its desired performance in terms of bandwidth, signal to noise ratio, and stability. Unfortunately these requirements cannot be met.

Alternative amplification circuitry is proposed which does not require such a large feedback resistor. Examples include a trans impedance amplifier with a pseudo resistor as a feedback element and a direct analogue to digital converter, obviating the need for a transimpedance amplifier. Two examples of a direct analogue to digital converter are: using a low duty cycled switched resistor, and using a reference capacitor. An optional arrangement is to remove the analogue to digital converter 558 from the cells 550 so that a circuit wire 570 connects the trans impedance amplifier 556 in the cell 550 with the analogue to digital converter external to the cell array 552, **FIG. 10C****.** The arrangement depicted in **FIG. 10C** may be applied to an amplifier circuit. Each option is now mentioned in turn. The example amplifier circuits described are just some of the suitable types of amplification circuitry that can be used. Other amplifier circuits may exist which achieve similar benefits to those described herein and which use similar circuit architecture for each cell as herein described.

An alternative amplification circuit is a direct analogue to digital converter for example using a switched resistor or capacitor, that are connected directly to the output of a detector elements 503. A suitable type of direct analogue to digital converter is a charge-balancing direct current-to-digital converter. Using a direct analogue to digital to converter avoids using a trans impedance amplifier and having the feedback resistor Rf or an exotic alternative. Removing the transimpedance amplifier removes the most power consuming component in the amplification circuit and the main source of input noise. Delta/sigma modulators provide the best realization of charge-balancing direct current-to-digital converter. Two possible solutions are: using as a reference a low duty cycle switched resistor; and using as a reference a switched capacitor. These circuits are exemplary and other suitable circuits may exist

As depicted in **FIG. 10C****,** a cell 550 comprises a transimpedance amplifier 556 connected to a detector element 560. Associated with this amplification circuitry is an effective feedback resistor 568. The output of the transimpedance amplifier is connected to an analogue to digital converter 558 (not shown) which is remote from the cell. A circuit wire 570 connects the trans impedance amplifier and the analogue to digital converter. The circuit wire 570 transmits an analogue signal. Considering that cell array 552 is densely packed, the analogue to digital to converter is external to the cell array for example one the same die as the cell array 552 and/or monolithically integrated with the cell array 552. In an embodiment the analogue to digital converter 558 is in the substrate of the detector module. Alternatively the analogue to digital converter is remote from the substrate, for example it is part of a processor external to the substrate.

The differences in components between the cells depicted in **FIG. 10B and FIG. 10C** are that the cell of **FIG. 10C** only includes a trans impedance amplifier and not an analogue to digital convert and the circuit wire 270 transmits an analogue signal rather than the digital signal transmitted by the analogue to digital converter. By removing the analogue to digital converter from the cell 550, there is more space available in the circuit layer of the cell 550 for a feedback resistor element. This relative difference can be noted by the relative size of the feedback resistor areas 562 in **FIG. 10B** and **FIG. 10C****;** (but note, the relative dimensions do not necessarily apply to other features of these two figures). There is yet more space in the circuit layer of the cell 550 if the amplifier circuitry uses an alternative trans impedance amplifier circuit, for example if a trans impedance amplifier with a pseudo resistor is used as a feedback element.

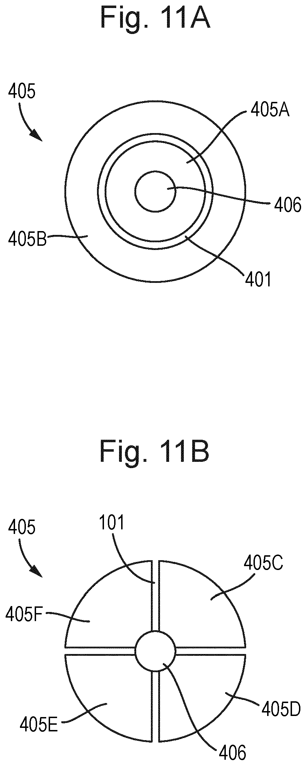

**FIG. 11A** shows a bottom view of a detector element 405 of a detector. The detector is for use in a charged particle device for an assessment apparatus. The detector is configured to detect electrons from the sample 208.

As shown in **FIG. 11A****,** in an embodiment the detector element 405 comprises at least two detector components 405A, 405B. Each detector component 405A, 405B is configured to detect signal particles emitted from the sample 208.

In an embodiment each detector component 405A, 405B is set to a respective bias electric potential. The bias electric potential may correspond to a potential difference between the detector component and, for example, the sample 208. The bias electric potential can be positive, negative or zero. In an embodiment there is a potential difference between the respective bias electric potentials. The bias electric potentials for the detector components 405A, 405B are different from each other. The bias electric potentials affect the likelihood of signal particles being detected by the detector components 405A, 405B.

In an embodiment each detector component 405A, 405B is configured to detect a respective species of signal particle. The relationship between the bias electric potential and the likelihood of a signal particle being detected by the detector component may be different for different species of signal particle. By using different bias voltages for the different detector components 405A, 405B, the possibility of one species of signal particle being detected by a detector component that is intended to detect a different species of signal particle. An embodiment of the invention is expected to reduce the possibility of cross signals in the detector 405.

Different species of signal particles may, in general, correspond to different energy ranges. In an embodiment the detector components 405A, 405B comprise a first detector component configured to detect signal particles above a first energy threshold. The first detector component is set to a first bias electric potential. The first detector component is configured to detect higher energy charged particles.

In an embodiment the detector components 405A, 405B comprise a second detector component configured to detect signal particles below a second energy threshold. The second detector component is set to a second bias electric potential. The second detector component is configured to detect lower energy charged particles.

For example, in an embodiment the first energy threshold corresponds to the minimum energy of a backscatter signal particle. Generally backscatter charged particles have greater energy than secondary charged particles. Backscatter charged particles that are detected may have a minimum energy of a few 100 eV. In an embodiment the first energy threshold is 100 eV, or 200 eV, or 500 eV.

The second energy threshold may corresponds to the energy of a secondary signal particle. Secondary charged particles may have a maximum energy of about 50 eV. In an embodiment the second energy threshold is 100 eV, or 50 eV. It may be that the first energy threshold and the second energy threshold are substantially the same. For example, both thresholds may be 50 eV or 100 eV. Alternatively, the energy thresholds may have an offset. For example, the first energy threshold may be 100 eV and the second energy threshold may be 50 eV. There may be an offset of 50 eV between the energy thresholds.

It will be understood from the description of the secondary and backscatter signal particles above that the threshold value (e.g. of 50 eV, or 100 eV, or 200 eV) between the different types of signal particles is arbitrary. There is not a black and white division around (i.e. distinct separation at) this threshold. The precise selection of the threshold value is unlikely much to improve or contribute to the image contrast or quality. Thus the selection of the threshold value is unlikely to reduce the detection of signal particles with borderline energy levels.

The first detector component may be referred to as a backscatter detector component 405B. The first bias electric potential may be referred to as a backscatter bias electric potential. The backscatter detector component 405B is configured to detect backscatter charged particles. The second detector component may be referred to as a secondary detector component 405A. The second bias electric potential may be referred to as a secondary bias electric potential. The secondary detector component 405A is configured to detect secondary charged particles.

There is a potential difference between the backscatter bias electric potential and the secondary bias electric potential. In an embodiment the backscatter bias electric potential and the secondary bias electric potential are set relative to the sample 208 so as to reduce detection of lower energy charged particles by the backscatter detector component. This reduces the cross signal of, for example secondary charged particles detected by the backscatter detector component 405B. The reduction in the detection of lower energy charged particles by the backscatter detector component 405B is a reduction compared to if the backscatter bias electric potential were set to be the same as the secondary bias electric potential. Application of the bias electric potentials set relative to the detector components may be considered to have the effect of a filter. The filter may help prevent signal particles outside the preferred energy range for a selected detector component from reaching the selected detector. The filter may prevent signal particles outside the preferred energy range from being detected by the selected and corresponding detector component.

For example, in an embodiment the secondary bias electric potential is set relative to the sample 208 so as to attract the lower energy charged particles to the secondary detector component 405A. The secondary bias electric potential may be positive relative to the sample 208. The positive bias electric potential attracts the lower energy charged particles to the secondary detector component 405A. The secondary bias electric potential increases the possibility of interaction between the secondary charged particles and the secondary detector component 405A.

If the backscatter bias electric potential were set to be the same as the secondary bias electric potential, for example positive, then more secondary charged particles may be detected by the backscatter detector component 405B compared to setting the backscatter bias electric potential to be less positive or more negative than the secondary bias electric potential.

In an embodiment the backscatter bias electric potential and the secondary bias electric potential are set relative to the sample 208 such that the lower energy charged particles are more attracted by the secondary detector component 405A than by the backscatter detector component 405B. Merely as an example, the secondary bias electric potential may be at least 5 V, optionally at least 10 V, and optionally at least 20 V relative to the sample 208 in order to increase detection of the secondary charged particles.

In an embodiment the backscatter bias electric potential is set relative to the sample 208 so as to repel lower energy charged particles from the backscatter detector component 405B. The backscatter bias electric potential may be negative. However, it is not essential for the backscatter bias electric potential to be negative. In an embodiment the backscatter bias electric potential is at most 10 V, optionally at most 5 V, optionally negative, optionally at most -5 V, optionally at most -10 and optionally at most -20 V relative to the sample 208.

Secondary charged particles emitted from the sample 208 toward the backscatter detector component 405B may be decelerated. In particular, the deceleration of the signal particles causes the signal particles which do not have too much kinetic energy to be mirrored back in the direction of the sample 208. The possibility of detection of the secondary charged particles by the backscatter detector component 405B is reduced. An embodiment of the invention is expected to lower the cross-signal in the backscatter detector component 405B.

As shown in **FIG. 11A** and **FIG. 11B****,** in an embodiment the backscatter detector component 405B and the secondary detector component 405A are positioned adjacent to each other. In an embodiment the distance between the detector component and the surface of the sample 208 is the same for the different types of detector component. In an alternative embodiment the distance between the detector component and the surface of the sample 208 is different for the different types of detector component. For example, in an embodiment the distance between the backscatter detector component and the sample 208 is less than the distance between the secondary detector component and the sample 208. By increasing the distance from the sample 208 to the secondary detector component, the possibility of detecting backscatter charged particles at the secondary detector component can be reduced. Meanwhile, by providing the backscatter detector component close to the sample 208, the detection efficiency at the backscatter detector component is maintained.

As shown in **FIG. 11A****,** in an embodiment the backscatter detector component 405B and the secondary detector component 405A each comprise concentric annuli. Alternatively, the detector may comprise different shapes. For example, the backscatter detector component 405B and the secondary detector component 405A may each comprise a region between two concentric squares, rectangles, rhombi or hexagons. Concentric detector components may be well suited to inspecting features of a layer buried under a surface of the sample 208.

As shown in **FIG. 11A****,** in an embodiment the backscatter detector component 405B is radially outward of the secondary detector component 405A. The charged particle beam projected toward the sample 208 can be affected by the bias electric potentials applied to the detector 405. The electromagnetic field associated with the secondary detector component 405A may at least partly shield a charged particle beam through the aperture 406 from the electromagnetic field associated with the backscatter detector component 405B. The charged particles that are projected toward the sample 208 may be substantially unaffected by the setting of the backscatter bias electric potential. An embodiment of the invention is expected to reduce cross detection signals without adversely affecting the projection of charged particles toward the sample 208.

As shown in **FIG. 11A****,** in an embodiment the detector 405 comprises two detector components 405A, 405B. In an alternative embodiment the detector 405 comprises more than two detector components, such as three, four or more than four detector components.

It is not essential for the detector components 405A, 405B to be divided radially. As shown in **FIG. 11B****,** in an alternative embodiment the backscatter detector component 405B and the secondary detector component 405A each comprise sectors 405C, 405D, 405E, 405F. The sectors 405C, 405D, 405E, 405F may be angularly divided, as shown in **FIG. 11B****.** Angularly divided sectors may be better suited when inspecting features of the surface of the sample 208 that have a high aspect ratio. Alternatively, the sectors may be divided by dividing lines that comprise both radial and circumferential components. In a further alternative embodiment the sectors are divided from each other both radially and angularly. By providing circle segments, it is possible to detect signal particles having different emission angles from the sample 208.

As shown in **FIG. 11B****,** in an embodiment the detector 405 comprises four sectors 405C, 405D, 405E, 405F. The sectors 405C, 405D, 405E, 405F may each form a quadrant. In an alternative embodiment the number of sectors of the detector 405 is two, three or more than four such as eight, twelve or more. The shape of the sectors may depend on the number of sectors. For example, each sector may correspond to the shape of a part of an annulus. In an embodiment the sectors 405C, 405D, 405E, 405F have approximately the same area as each other. Alternatively, one or more sectors may be large than one or more other sectors.

In an embodiment a plurality of the sectors are set to the same bias electric potential so as to detect the same species of charged particles. For example, in an embodiment opposing sectors 405C, 405E are configured to detect backscatter charged particles. The other opposing sectors 405D, 405F are configured to detect secondary charged particles. Alternatively, adjacent sectors 405C, 405D are configured to detect backscatter charged particles. The other adjacent sectors 405E, 405F are configured to detect secondary charged particles.

Alternatively the number of sectors for detecting different species of charged particles may be different. For example, one sector 405C may be configured to detect backscatter charged particles. The other sectors 405D, 405E, 405F may be configured to detect secondary charged particles.

In an embodiment the detector 405 is configured to detect two different species of charged particles. In an embodiment the detector 405 is configured to detect more than two different species of charged particles.

In an embodiment the distance L from a surface of the sample 208 facing the detector 405 to a surface of the detector 405 is at most 10 µm, optionally at least 20 µm, optionally at least 50 µm, and optionally at least 100 µm. By increasing the working distance L, the solid angle of the secondary detector component 405A from the sample 208 is reduced. By increasing the distance L, the detection of backscatter charged particles by the secondary detector component 405A can be reduced. Conversely, by decreasing the distance L, the detection of backscatter charged particles by the secondary detector component 405A can be increased.

As sown in **FIG. 11A** and **FIG. 11B****,** in an embodiment the backscatter detector component 405B is electrically isolated from the secondary detector component 405A. The detector components 405A, 405B may be separated from each other. For example, as shown in **FIG. 11A** in an embodiment the detector 405 comprises an isolator 101 between the backscatter detector component 405B and the secondary detector component 405A. The isolator is configured to electrically isolate the detector components 405A, 405B from each other. In an embodiment the isolator 101 comprises an electrically insulating material. Alternatively, the detector components 405A, 405B may be simply spaced apart from each other. In an embodiment the potential difference between the detector components 405A, 405B is at most 50 V, optionally at most 20 V, optionally at most 10 V and optionally at most 5 V. An embodiment of the invention is expected to reduce the possibility of electrical breakdown caused by the voltage difference between the detector components 405A, 405B.

In an embodiment, the width (e.g. diameter) of the secondary detector component 405A may be approximately 2 µm to 100 µm and/or the width of the backscatter detector component 405B may be approximately 10 µm to 250 µm. In an embodiment the detector components 405A, 405B are separated from each other by a distance of at least 100 nm, optionally at least 200 nm, optionally at least 500 nm, optionally at least 1 µm, optionally at least 2 µm, and optionally at least 5 µm. Increasing the separation distance can reduce the possibility of electrical breakdown. In an embodiment the detector components 405A, 405B are separated from each other by a distance of at most 5 µm, optionally at most 2 µm, optionally at most 1 µm, optionally at most 500 nm, optionally at most 200 nm, and optionally at most 100 nm. Decreasing the separation distance can increase the proportion of the detector 405 that is actively used for detection of signal particles.

In an embodiment, the backscatter detector component 405B comprises a charge-detection based element. The charge-detection based element is set to the backscatter bias electric potential. The charge-detection based element is configured to detect the higher energy charged particles such as the backscatter charged particles. In an embodiment the secondary detector component 405A comprises a charge-detection based element. The charge-detection based element of the secondary detector component 405A is set to the secondary bias electric potential. The charge-detection based element of the secondary detector component 405A is configured to detect the lower energy charged particles such as the secondary charged particles. Both of the detector components 405A, 405B may be configured to detect signal particles by detecting the charge of the signal particles.

As shown in in **FIG. 11A** and **FIG. 11B****,** in an embodiment the detector 405 comprises a substrate in which is defined an aperture 406 for the passage therethrough of a charged particle beam. The charged particle beam that is projected toward the sample 208 can pass through the aperture 406 in the detector 405. In an alternative embodiment the charged particle beam may pass adjacent to the detector 405. Accordingly, it may not be necessary for the aperture 406 to be provided. In another arrangement the detector 405 may have two elements either side of the beam. The parts may define a slit therebetween. The two parts may be unconnected. The radially inner detector component such as the secondary detector component 405A may be circular, or another shape such as square, rectangular, rhombic or hexagonal.

In an embodiment a charged particle device for an assessment apparatus comprises an objective lens 241. An aperture for the charged particle beam may be defined in the objective lens 241. In an embodiment the aperture 406 of the detector 405 is aligned with the aperture of the objective lens 241. At least one detector 405 of the detector system may be structurally connected to the objective lens 241. For example, the detector 405 may be associated with a major surface of an electrode plate of the objective lens 241. The detector 405 may provide a surface of the charged particle device. That surface may be arranged to face the sample 208. The detector 405 may form the final surface of the charged particle device above the sample 208.

The detector 405 may be positioned relative to the sample holder 207 so that the detector 405 is proximate to the sample 208. The detector may be positioned relative to the sample holder 207 so that the detector 405 is the first charged particle-optical component that charged particles emitted from the sample 208 encounter. Signal particles emitted from the sample 208 can be emitted directly to the detector 405. The region between the detector 405 and the sample 208 may be free space, unaffected by any electron-optical components such as electrodes.

As described above, in an embodiment a detector array 240 is provided. The detector array 240 comprises a plurality of detectors 405 as described above. The detectors 405 are for detecting charged particles from the sample 208 resulting from respective charged particle beams, for example respective sub-beams of a multi-beam. The detector array 240 may be provided as part of a multi-beam apparatus. The beam of charged particles may be a plurality of sub-beams, and the aperture defined in the objective lens 241 may be a plurality of apertures. Each aperture may be associated with a respective sub-beam, the detector 405 may comprise a plurality of respective detector components, at least two detector components being associated with each sub-beam.

In an embodiment the detector array 240 comprises a substrate in which is defined a plurality of apertures for the passage therethrough of a plurality of charged particle beams. The substrate of the detector array 240 may comprise at least two detector components 405A, 405B associated with each aperture. Each of the detector components 405A, 405B may be set to a respective bias electric potential and configured to detect a respective species of signal particle. There is a potential difference between the respective bias electric potentials.

Alternatively, in an embodiment the detector 405 is provided as part of a single beam apparatus, for example as shown in **FIG. 9****.** The detector 405 may be provided as a single detector. Alternatively, a plurality of detectors 405 may be provided as part of the single beam apparatus.

In an embodiment the detector 405, possibly as a detector array 240 is provided at a single distance from the sample 208. In an alternative embodiment, a plurality of detectors 405 or detector arrays 240 are provided at different distances from the sample 208. In an embodiment at least one detector 405 is provided up-beam of the objective lens 241.

In an embodiment, there is provided a method of projecting a beam of charged particles onto a sample 208 so as to detect signal particles emitted from the sample, 208. In an embodiment the method comprises projecting the beam along a primary beam path onto a surface of the sample 208. In an embodiment the method comprises detecting the signal particles emitted from the sample 208 simultaneously at a backscatter detector component 405B set to a backscatter bias electric potential and at a secondary detector component 405A set to a secondary bias electric potential. There is a potential difference between the backscatter bias electric potential and the secondary bias electric potential. In an embodiment the controller 50 is configured to control the bias electric potentials for the detector components of the detector 405.

As described above, different detector components of the detector 405 can be configured to detect different species of signal particles by setting different bias electric potentials for the different detector components. This can help to reduce cross signals. Another way of configuring the detector elements to detect different species of signal particles is explained below. Features of the embodiments above are applicable to the embodiments described below but are not all repeated in order to improve conciseness.

In an embodiment the detector 405 comprises at least two detector components 405A, 405B of different types. For example, in an embodiment one detector component is a backscatter detector component 405B configured to detect higher energy charged particles and another detector component is a secondary detector component 405A configured to detect lower energy charged particles. The backscatter detector component 405B and the secondary detector component 405A are of different types.

As explained above, at least one of the detector components may be configured to detect charged particles having an energy above the first energy threshold. Another of the detector components may be configured to detect charged particles below the second energy threshold. The description of the first energy threshold and the second energy threshold provided above is applicable to embodiments in which the detector 405 comprises at least two detector components 405A, 405B of different types.

In an embodiment the secondary detector component 405A comprises a charge-detection based element configured to detect the lower energy charged particles such as the secondary charged particles. Such a charge-detection based element is suitable for detecting signal particles that have a relatively low kinetic energy, e.g. less than 100 eV.

In an embodiment a type of detector different from a charge-detection based element is used for the backscatter detector component 405B. For example, in an embodiment at least one backscatter detector component 405B comprises a semiconductor element (e.g. a PIN detector) configured to detect the higher energy charged particles. In an embodiment at least one backscatter detector component 405B comprises a scintillator element configured to detect the higher energy charged particles. Such a type of detector can detect backscatter charged particles with sufficiently high energy (e.g. up from a few 100 eV, or possibly even lower). Such a type of detector may be less suited than a charge-detection based element for detecting lower energy charged particles. Scintillators and PIN detectors are typically capable of detecting charged particles above a detection threshold for example typically above approximately 1 keV, although lower values for example 200 eV for PIN detectors are known. For a scintillator the detection threshold may be varied by the selection of the thickness of a conductive coating, such as a metal layer, on the scintillator surface. An embodiment of the invention is expected to reduce detection of secondary charged particles by the backscatter detector component 405B.

A semiconductor or scintillator based detector may be more suited than a charge-detection based element for detecting backscatter charged particles. This is particularly the case when the working distance L is small. A small distance L can lead to shallower impact angles of the backscatter charged particles on the charged-based detector, which could reduce the accuracy of detection. At shallow impact angles the probability of backscatter charged particles scattering back out again of the detector increases, and also the secondary charged particle yield generated by a backscatter charged particle increases. Furthermore, when a negative bias is applied the secondary charged particles are less attracted to the detector. It is possible that more charged particles could leave the detector than enter the detector per impact of a backscatter charged particle, resulting in the measurement of a positive current instead of the expected negative current. A semiconductor or scintillator based detector may be more suited than a negatively biased charge-detection based element for detecting backscatter charged particles.

In an embodiment the secondary detector component 405A is set to a secondary bias electric potential relative to the sample 208 so as to attract the lower energy charged particles to the secondary detector component 405A. The secondary bias electric potential may be positive. The secondary bias electric potential may be selected to have a value as described above. The secondary bias electric potential may increase detection of the secondary charged particles by the secondary detector component 405A.

In an embodiment the backscatter detector component 405B is electrically connected to the secondary detector component 405A. For example, the detector components 405A, 405B may be in contact with each other, as shown in **FIG. 6A****,** for example. In an embodiment the backscatter detector component 405B and the secondary detector component 405A are set to the same electric potential. This can increase detection of charged particles by the different detector components 405A, 405B. Alternatively, as described above different bias voltages may be used for the different detector components 405A, 405B. This can reduce the possibility of one species of signal particle being detected by a detector component that is intended to detect a different species of signal particle. An embodiment of the invention is expected to reduce the possibility of cross signals in the detector 405.

In an embodiment the backscatter detector component 405B comprises an electrically conductive layer. The electrically conductive layer may comprise a metal. The electrically conductive layer may be a coating layer. The electrically conductive layer may for the surface of the backscatter detector component 405B that faces the sample 208, i.e. the exterior surface of the backscatter detector component 405B. The electrically conductive layer may be set to the bias electric potential.

In an embodiment the backscatter detector component 405B comprises an electrically insulating layer. The electrically insulating layer may be adjacent to the electrically conductive layer. In an embodiment the electrically insulating layer is configured to block the lower energy charged particles from being detected by the backscatter detector component 405B. Higher energy charged particles may pass through the electrically insulating layer in order to be detected. The electrically insulating layer near the detector surface may reduce or eliminate detection of secondary electrons by the backscatter detector component 405B.

The physical shape and arrangement of the detector components may be varied and selected as described above in relation to other embodiments. For example, as shown in **FIG. 6B** the detector components may be provided as angularly divided sectors instead of radially divided annuli.

As described above, the detector 405 may be part of a detector array 240. The detector array 240 may be for use in a charged particle device for an assessment apparatus to detect charged particles from the sample 208. The detector array 240 may comprise a substrate comprising at least two detector components 405A, 405B of different types.

The detector 405 as described in any of the above variations can work both with decelerating and accelerating objective lenses (i.e. with the device working in a decelerating or an accelerating mode). In particular, when the detector 405 is positioned as a bottom detector (e.g. down-beam of the objective lens array 241), the signal particle trajectories towards the detector 405 are determined by the field between the sample 208 and the detector 405, not by the decelerating or accelerating field of the objective lens array 241. By applying negative or positive bias on the detector 405 or detector array with respect to the sample 208, low energy signal particles (e.g. secondary signal particles) can either be repelled (backscatter-only mode) or attracted (combined secondary and backscatter mode). It is noted that higher landing energies are typically used with the accelerating lens. This means that the high energy signal particles (e.g. the backscatter signal particles) have higher energies on average in this case.

The detector 405 may be provided as part of a multi-beam apparatus or as part of a single beam apparatus. The detector 405 described above may be used in a single beam device, e.g. in combination with the device described in relation to **FIG. 9****.** Alternatively, the detector could be used in a multi-beam device, e.g. in which a primary beam is separated into sub-beams, for example as described in relation to **FIG. 3** and **FIG. 8****.** Thus, multiple detectors may be provided which may be suitable for use in a multi-beam charged particle device. The multiple detectors could be provided as described in any of the above variations or embodiments. The multiple detectors may form an array which may be referred to as a detector array. In this case, each detector may be configured as described above and may be positioned adjacent to other detectors in an array. Each of the detectors may have the same configuration as each other, e.g. with all the detectors having a detector element configuration as shown in **FIG. 11A****,** or the configuration as shown in **FIG. 11B****.** A plurality of detectors 405 may be provided at different distances from the sample 208.

In an embodiment there is provided a method of projecting a beam of charged particles onto a sample 208 so as to detect signal particles emitted from the sample 208. In an embodiment the method comprises projecting the beam along a primary beam path onto a surface of the sample 208. In an embodiment the method comprises detecting the signal particles emitted from the sample 208 simultaneously at a backscatter detector component 405B and at a secondary detector component 405A, wherein the backscatter detector component 405B and the secondary detector component 405A are of different types.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons. The charged-particle optical device may be a negative charged particle device. The charged-particle optical device may otherwise be referred to as an electron-optical device. It will be understood that an electron is a specific charged particle and can replace all instances of charged particle referred to throughout the application as appropriate. For example, the source may specifically provide electrons. The charged particle referred to throughout the specification may be specifically a negatively charged particle.

The charged particle-optical device may more specifically be defined as a charged particle-optical column. In other words, the device may be provided as a column. The column may thus comprise an objective lens array assembly as described above. The column may thus comprise a charged particle optical system as described above, for example comprising an objective lens array and optionally a detector array and/or optionally a condenser lens array.

The charged particle optical device described above comprises at least the objective lens array 240. The charged particle optical device may comprise the detector array 241. The charged particle optical device may comprise the control lens array 250. The charged particle optical device comprising the objective lens array and the detector array may thus be interchangeable with, and referred to as, the objective lens array assembly, which may optionally comprise the control lens array 250. The charged particle optical device may comprise additional components described in relation to either of **FIG. 3** and/or **FIG. 8****.** Thus, the charged particle optical device may be interchangeable with, and referred to as, a charged particle assessment tool 40 and/or a charged particle optical system if comprising the additional components in these figures.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle-optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or charged particle-optical elements arranged in arrays along a beam or a multi-beam path. Such charged particle-optical elements may be electrostatic. In an embodiment all the charged particle-optical elements, for example from a beam limiting aperture array to a last charged particle-optical element in a sub-beam path before a sample, may be electrostatic and/or may be in the form of an aperture array or a plate array. In some arrangements one or more of the charged particle-optical elements are manufactured as a microelectromechanical system (MEMS) (i.e. using MEMS manufacturing techniques).

The system or device of such architectures as depicted in at least **FIG. 3** and **FIG. 8** and as described above may comprise components such as an upper beam limiter, a collimator element array 271, a control lens array 250, a scan deflector array 260, an objective lens array 241, a beam shaping limiter and/or a detector array 240; one or more of these elements that are present may be connected to one more adjacent elements with an isolating element such as a ceramic or glass spacer.

A computer program may comprise instructions to instruct the controller 50 to perform the following steps. The controller 50 controls the charged particle beam apparatus to project a charged particle beam towards the sample 208. In an embodiment the controller 50 controls at least one charged particle-optical element (e.g. an array of multiple deflectors or scan deflectors 260, 265) to operate on the charged particle beam in the charged particle beam path. Additionally or alternatively, in an embodiment the controller 50 controls at least one charged particle-optical element (e.g. the detector array 240) to operate on the charged particle beam emitted from the sample 208 in response to the charged particle beam.

Any element or collection of elements may be replaceable or field replaceable within the charged particle beam tool 40. The one or more charged particle-optical components in the charged particle beam tool 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There are provided the following clauses:
Clause 1: A detector for use in a charged particle device for an assessment apparatus to detect charged particles from a sample, wherein the detector comprises: a backscatter detector component set to a backscatter bias electric potential and configured to detect higher energy charged particles; and a secondary detector component set to a secondary bias electric potential and configured to detect lower energy charged particles; wherein there is a potential difference between the backscatter bias electric potential and the secondary bias electric potential.
Clause 2: A detector for use in a charged particle device for an assessment apparatus to detect charged particles from a sample, the detector comprising a substrate comprising: at least two detector components each set to a respective bias electric potential and configured to detect a respective species of signal particle; wherein there is a potential difference between the respective bias electric potentials.
Clause 3: The detector of clause 2, wherein the detector components comprise a first detector component configured to detect signal particles above a first energy threshold and set to a first bias electric potential; and/or a second detector component configured to detect signal particles below a second energy threshold and set to a second bias electric potential.
Clause 4: The detector of clause 3, wherein the first energy threshold corresponds to the minimum energy of a backscatter signal particle.
Clause 5: The detector of clause 3 or 4, wherein the second energy threshold corresponds to the energy of a secondary signal particle.
Clause 6: The detector of any of clauses 3 to 5, wherein the first energy threshold and the second energy threshold are substantially the same or have an offset.
Clause 7: The detector of any of clauses 3 to 6, wherein the first detector component is a backscatter detector component set to backscatter bias electric potential and configured to detect backscatter charged particles and the second detector component is a secondary detector component set to a secondary bias electric potential and configured to detect secondary charged particles.
Clause 8: The detector of clause 1 or 7, wherein the backscatter bias electric potential and the secondary bias electric potential are set relative to the sample so as to reduce detection of lower energy charged particles by the backscatter detector component.
Clause 9: The detector of any of clauses 1, 7 and 8, wherein the secondary bias electric potential is set relative to the sample so as to attract the lower energy charged particles to the secondary detector component.
Clause 10: The detector of any of clauses 1 and 7 to 9, wherein the backscatter bias electric potential and the secondary bias electric potential are set relative to the sample such that the lower energy charged particles are more attracted by the secondary detector component than by the backscatter detector component.
Clause 11: The detector of any of clauses 1 and 7 to 10, wherein the backscatter bias electric potential is set relative to the sample so as to repel lower energy charged particles from the backscatter detector component.
Clause 12: The detector of any of clauses 1 and 7 to 11, wherein the backscatter detector component comprises a charge-detection based element set to the backscatter bias electric potential and configured to detect the higher energy charged particles.
Clause 13: The detector of any of clauses 1 and 7 to 12, wherein the secondary detector component comprises a charge-detection based element set to the secondary bias electric potential and configured to detect the lower energy charged particles.
Clause 14: The detector of any of clauses 1 and 7 to 13, wherein the backscatter detector component is electrically isolated from the secondary detector component.
Clause 15: The detector of clause 14, wherein the detector comprises an isolator between the backscatter detector component and the secondary detector component.
Clause 16: The detector of any of clauses 1 to 15, wherein the at least two detector components are of different types.
Clause 17: A detector for use in a charged particle device for an assessment apparatus to detect charged particles from a sample, wherein the detector comprises: a backscatter detector component configured to detect higher energy charged particles; and a secondary detector component configured to detect lower energy charged particles; wherein the backscatter detector component and the secondary detector component are of different types.
Clause 18: A detector for use in a charged particle device for an assessment apparatus to detect charged particles from a sample, the detector comprising a substrate comprising: at least two detector components of different types.
Clause 19: The detector of clause 18, wherein at least one of the detector components is configured to detect charged particles having an energy above a first energy threshold; and optionally another of the detector components is configured to detect charged particles below a second energy threshold.
Clause 20: The detector of clause 19, wherein the first energy threshold corresponds to the minimum energy of a backscatter signal particle.
Clause 21: The detector of clause 19 or 20, wherein the second energy threshold corresponds to the maximum energy of a secondary signal particle.
Clause 22: The detector of any clauses 19 to 21, wherein the first energy threshold and the second energy threshold are substantially the same or have an offset.
Clause 23: The detector of any clauses 19 to 22, wherein a first detector component is a backscatter detector component configured to detect backscatter charged particles and a second detector component is a secondary detector component configured to detect secondary charged particles.
Clause 24: The detector of clause 17 or 23, wherein the secondary detector component comprises a charge-detection based element configured to detect the lower energy charged particles.
Clause 25: The detector of any of clauses 17, 23 and 24, wherein the backscatter detector component comprises a semiconductor element configured to detect the higher energy charged particles.
Clause 26: The detector of any of clauses 17 and 23 to 25, wherein the backscatter detector component comprises a scintillator element configured to detect the higher energy charged particles.
Clause 27: The detector of any of clauses 17 and 23 to 26, wherein the secondary detector component is set to a secondary bias electric potential relative to the sample so as to attract the lower energy charged particles to the secondary detector component.
Clause 28: The detector of any of clauses 17 and 23 to 27, wherein the backscatter detector component is electrically connected to the secondary detector component.
Clause 29: The detector of any of clauses 17 and 23 to 28, wherein the backscatter detector component and the secondary detector component are set to the same electric potential.
Clause 30: The detector of any of clauses 1, 8 to 17 and 23 to 29, wherein the backscatter detector component and the secondary detector component are positioned adjacent to each other.
Clause 31: The detector of clause 30, wherein the backscatter detector component and the secondary detector component each comprise concentric annuli which are preferably radially divided.
Clause 32: The detector of clause 31, wherein the backscatter detector component is radially outward of the secondary detector component.
Clause 33: The detector of any of clauses 30 to 32, wherein the backscatter detector component and the secondary detector component each comprise sectors which are preferably angularly divided.
Clause 34: The detector of any preceding clause, wherein the detector comprises a substrate in which is defined an aperture for the passage therethrough of one or more charged particle beams.
Clause 35: A detector array comprising a plurality of the detector of any preceding clause, the detectors being for detecting charged particles from the sample resulting from respective charged particle beams.
Clause 36: A charged particle device for an assessment apparatus to detect charged particles from a sample, the device comprising: an objective lens configured to project a beam of charged particles onto a sample, and in which an aperture is defined for the beam; and a detector system comprising the detector of any of clauses 1 to 34 or the detector array of clause 35, wherein the detector aperture is aligned with the aperture in the objective lens.
Clause 37: The charged particle device of clause 36, wherein at least one detector of the detector system is structurally connected to the objective lens.
Clause 38: The charged particle device of clause 36 or 37, wherein at least one detector of the detector system is associated with a major surface of an electrode plate of the objective lens.
Clause 39: The charged particle device of any of clauses 36 to 38, wherein at least one detector of the detector system provides a surface of the charged particle device.
Clause 40: The charged particle device of clause 39, wherein at least one detector of the detector system is configured to face the sample.
Clause 41: The charged particle device of any of clauses 36 to 40, wherein at least one detector of the detector system is provided up-beam of the objective lens.
Clause 42: The charged particle device of any of clauses 36 to 41, comprising: a sample holder configured to hold the sample.
Clause 43: The charged particle device of clause 42, wherein the detector is positioned relative to the sample holder so that the detector is proximate to the sample.
Clause 44: The charged particle device of clause 42 or 43, wherein the detector is positioned relative to the sample holder so that the detector is the first charged particle-optical component that charged particles emitted from the sample encounter.
Clause 45: The charged particle device of any of clauses 42 to 44, wherein the detector is distanced from the sample holder so that the detector is distanced from the sample by at least 10µm, and optionally at least 20µm.
Clause 46: The charged particle device of any of clauses 36 to 45, wherein the beam of charged particles is a plurality of sub-beams, the aperture defined in the objective lens is a plurality of apertures each associated with a respective sub-beam, the detector comprising a plurality of respective components, at least two components being associated with each sub-beam.
Clause 47: A method of projecting a beam of charged particles onto a sample so as to detect signal particles emitted from the sample, the method comprising: a) projecting the beam along a primary beam path onto a surface of the sample; and b) detecting the signal particles emitted from the sample simultaneously at a backscatter detector component set to a backscatter bias electric potential and at a secondary detector component set to a secondary bias electric potential, wherein there is a potential difference between the backscatter bias electric potential and the secondary bias electric potential.
Clause 48: A method of projecting a beam of charged particles onto a sample so as to detect signal particles emitted from the sample, the method comprising: a) projecting the beam along a primary beam path onto a surface of the sample; and b) detecting the signal particles emitted from the sample simultaneously at a backscatter detector component and at a secondary detector component, wherein the backscatter detector component and the secondary detector component are of different types.
Clause 49: A detector array for use in a charged particle device for an assessment apparatus to detect charged particles from a sample, the detector array comprising a substrate comprising: at least two detector components of different types.
Clause 50: A detector array for use in a charged particle device for an assessment apparatus to detect charged particles from a sample, the detector array comprising a substrate in which is defined a plurality of apertures for the passage therethrough of a plurality of charged particle beams, the substrate comprising; at least two detector components associated with each aperture, each of the detector components set to a respective bias electric potential and configured to detect a respective species of signal particle; wherein there is a potential difference between the respective bias electric potentials.
Clause 51: A charged particle device for an assessment apparatus to detect charged particles from a sample in response to a plurality of beams, the device comprising: an objective lens configured to project a plurality of beams of charged particles onto a sample, and in which is defined a plurality of apertures for each beam; and a detector system comprising the detector array of clause 50, wherein the detector apertures are aligned with the aperture in the objective lens, preferably wherein the detector array is proximate a sample.

## Claims

1. A detector for use in a charged particle device for an assessment apparatus to detect charged particles from a sample, the detector comprising a substrate comprising:
at least two detector components each set to a respective bias electric potential and configured to detect a respective species of signal particle;
wherein there is a potential difference between the respective bias electric potentials.

2. The detector of claim 1, wherein the detector components comprise:
a first detector component configured to detect signal particles above a first energy threshold and set to a first bias electric potential; and/or
a second detector component configured to detect signal particles below a second energy threshold and set to a second bias electric potential.

3. The detector of claim 2, wherein the first energy threshold corresponds to the minimum energy of a backscatter signal particle.

4. The detector of claim 2 or 3, wherein the second energy threshold corresponds to the energy of a secondary signal particle.

5. The detector of any of claims 2 to 4, wherein the first energy threshold and the second energy threshold are substantially the same or have an offset.

6. The detector of any of claims 2 to 5, wherein the first detector component is a backscatter detector component set to backscatter bias electric potential and configured to detect backscatter charged particles and the second detector component is a secondary detector component set to a secondary bias electric potential and configured to detect secondary charged particles.

7. The detector of claim 6, wherein the backscatter bias electric potential and the secondary bias electric potential are set relative to the sample so as to reduce detection of lower energy charged particles by the backscatter detector component.

8. The detector of claim 6 or 7, wherein the secondary bias electric potential is set relative to the sample so as to attract the lower energy charged particles to the secondary detector component.

9. The detector of any of claims 6 to 8, wherein the backscatter bias electric potential and the secondary bias electric potential are set relative to the sample such that the lower energy charged particles are more attracted by the secondary detector component than by the backscatter detector component.

10. The detector of any of claims 6 to 9, wherein the backscatter bias electric potential is set relative to the sample so as to repel lower energy charged particles from the backscatter detector component.

11. The detector of any of claims 6 to 10, wherein the backscatter detector component comprises a charge-detection based element set to the backscatter bias electric potential and configured to detect the higher energy charged particles.

12. The detector of any of claims 6 to 11, wherein the secondary detector component comprises a charge-detection based element set to the secondary bias electric potential and configured to detect the lower energy charged particles.

13. The detector of any of claims 6 to 12, wherein the backscatter detector component is electrically isolated from the secondary detector component.

14. The detector of claim 13, wherein the detector comprises an isolator between the backscatter detector component and the secondary detector component.

15. The detector of any proceeding claim of any proceeding claim, wherein the at least two detector components are of different types.
